(19) Europäisches Patentamt / European Patent Office / Office européen des brevets

(11) **EP 4 435 141 A1**

(12) **EUROPEAN PATENT APPLICATION**
published in accordance with Art. 153(4) EPC

(43) Date of publication:
**25.09.2024 Bulletin 2024/39**

(21) Application number: **22895531.6**

(22) Date of filing: **10.11.2022**

(51) International Patent Classification (IPC):
*C23C 14/34* (2006.01)    *C04B 35/495* (2006.01)
*H10N 30/853* (2023.01)

(52) Cooperative Patent Classification (CPC):
**C04B 35/495; C23C 14/34; H10N 30/853**

(86) International application number:
**PCT/JP2022/041920**

(87) International publication number:
**WO 2023/090249 (25.05.2023 Gazette 2023/21)**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority:  19.11.2021  JP 2021188741
19.11.2021  JP 2021188742
19.11.2021  JP 2021188743
19.11.2021  JP 2021188744
19.11.2021  JP 2021188745
08.11.2022  JP 2022179078

(71) Applicant: **Sumitomo Chemical Company, Limited Tokyo 103-6020 (JP)**

(72) Inventors:
• **NAKATA, Kunihiko**
  **Osaka-shi, Osaka 554-8558 (JP)**
• **NISHIOKA, Koji**
  **Osaka-shi, Osaka 554-8558 (JP)**

(74) Representative: **Vossius & Partner Patentanwälte Rechtsanwälte mbB Siebertstrasse 3 81675 München (DE)**

(54) **SPUTTERING TARGET MATERIAL AND SPUTTERING TARGET**

(57)    A sputtering target material includes a sintered ceramics of an oxide containing potassium, sodium, niobium, and oxygen, wherein when a volume resistivity at 25 °C is less than $6.0 \times 10^{11}$ $\Omega \cdot cm$, a Vickers hardness is 460 or more, and a flexural strength is 90 MPa or more, or wherein when a volume resistivity at 25 °C is $6.0 \times 10^{11}$ $\Omega \cdot cm$ or more, a Vickers hardness is 250 or more, and a flexural strength is 90 MPa or more.

**FIG. 1**

EP 4 435 141 A1

**Description**

TECHNICAL FIELD

The present disclosure relates to a sputtering target material and a sputtering target.

DESCRIPTION OF RELATED ART

There may be cases where a sputtering target material comprising a sintered ceramics of an oxide containing potassium, sodium, niobium, and oxygen (hereinafter referred to as "KNN target material", or also simply referred to as "target material") is used as a material for depositing a piezoelectric thin film (see Patent Document 1, for example).

PRIOR ART DOCUMENT

PATENT DOCUMENT

Patent Document 1: Japanese Patent Laid Open Publication No. 2011-146623

SUMMARY

PROBLEM TO BE SOLVED BY DISCLOSURE

An object of the present disclosure is to improve properties of a KNN target material.

MEANS FOR SOLVING PROBLEM

According to an aspect of the present disclosure,

there is provided a sputtering target material comprising a sintered ceramics of an oxide containing potassium, sodium, niobium, and oxygen, wherein
when a volume resistivity at 25 °C is less than $6.0 \times 10^{11}$ Ω·cm, a Vickers hardness is 460 or more, and a flexural strength is 90 MPa or more.

According to another aspect of the present disclosure,

there is provided a sputtering target material comprising a sintered ceramics of an oxide containing potassium, sodium, niobium, and oxygen, wherein
when a volume resistivity at 25 °C is $6.0 \times 10^{11}$ Ω·cm or more, a Vickers hardness is 250 or more, and a flexural strength is 90 MPa or more.

According to still another aspect of the present disclosure,
there is provided a sputtering target comprising:

the sputtering target material according to any of the aspects described above; and
a backing plate joined to the sputtering target material.

ADVANTAGE OF DISCLOSURE

According to the present disclosure, properties of a KNN target material can be improved.

BRIEF DESCRIPTION OF DRAWINGS

FIG. 1 is a diagram illustrating one aspect of a target material 10 of the present disclosure.
FIG. 2 is a diagram illustrating a production flow for the target material 10 of the present disclosure.
FIG. 3 is a schematic configuration diagram of a sintering apparatus 100 used in the present disclosure.

DETAILED DESCRIPTION OF THE DISCLOSURE

<One aspect of the present disclosure>

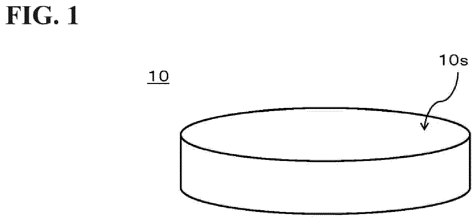

Hereinafter, one aspect of the present disclosure will be described mainly with reference to FIG. 1 to FIG. 3.

(1) Configuration of target material

A target material 10 according to the present aspect comprises a sintered ceramics comprising an oxide (alkali niobium oxide) mainly containing potassium (K), sodium (Na), niobium (Nb), and oxygen (O), that is, is composed of a KNN sintered ceramics. Crystal grains mainly included in the KNN sintered ceramics have a perovskite structure. To be more specific, the KNN sintered ceramics is expressed by a composition formula of $(K_{1-x}Na_x)NbO_3$ (0 < x < 1), wherein a coefficient x [= Na/(K + Na)] in the composition formula is 0 < x < 1, and is preferably $0.4 \leq x \leq 0.8$. The KNN sintered ceramics that forms the target material 10 of the present aspect is an oxide sintered ceramics substantially comprising potassium, sodium, niobium, and oxygen, or is an oxide sintered ceramics further comprising a dopant element described later. Here, "substantially comprising" means that 99 % or more of all atoms included in the KNN sintered ceramics consist of potassium, sodium, niobium, and oxygen. Alternatively, in the case where a KNN sintered ceramics contains a dopant element, "substantially comprising" means that 99 % or more of all atoms included in the KNN sintered ceramics consist of potassium, sodium, niobium, oxygen, and the dopant element.

A composition of K, Na, and Nb ((K + Na)/Nb) in the target material 10 satisfies the relationship of 0.90 or more and 1.25 or less, more preferably 0.95 or more and 1.20 or less, and further preferably 1.00 or more and 1.10 or less. In the present embodiment, K, Na, and Nb in the formula of (K + Na)/Nb denote the numbers of K atoms, Na atoms, and Nb atoms contained in the KNN sintered ceramics, respectively. Although the composition ratio of the target material 10 can also be estimated from the feed amounts of raw materials, the composition ratio can also be measured by a known method, and can be obtained by, for example, an inductively coupled plasma-atomic emission spectrometer (ICP-AES, (SPS5000 manufactured by Seiko Instruments Inc., for example)).

There may be cases where at least one element (dopant) selected from the group described later is added to the target material 10 at a concentration of, for example, 5 at% or less. Examples of the dopant include at least one element selected from the group consisting of lithium (Li), magnesium (Mg), calcium (Ca), strontium (Sr), barium (Ba), bismuth (Bi), antimony (Sb), vanadium (V), indium(In), tantalum (Ta), molybdenum (Mo), tungsten (W), chromium (Cr), titanium (Ti), zirconium (Zr), hafnium (Hf), scandium (Sc), yttrium (Y), lanthanum (La), cerium (Ce), praseodymium (Pr), neodymium (Nd), samarium (Sm), europium (Eu), gadolinium (Gd), terbium (Tb), dysprosium (Dy), holmium (Ho), erbium (Er), thulium (Tm), ytterbium (Yb), lutetium (Lu), copper (Cu), zinc (Zn), silver (Ag), manganese (Mn), iron (Fe), cobalt (Co), nickel (Ni), aluminum (Al), silicon (Si), germanium (Ge), tin (Sn), and gallium (Ga). In the case where the target material 10 contains a plurality of elements described above, the total concentration is 5 at% or less, and the addition amount of the dopant is usually 0.1 at% or more.

The target material 10 is shaped into a disk shape, for example. The target material 10 is joined (bonded) onto a backing plate (cooling plate), not shown in the drawing, comprising Cu or the like via a joining material containing In, Sn, or an alloy containing the above-mentioned metal, and is used as a sputtering target. Of both main surfaces of the target material 10, a surface different from a joint surface joined to the cooling plate is used as a surface exposed to plasma, such as argon (Ar), that is, a sputter surface 10s that releases atoms forming a film in performing a deposition process.

In the case where the target material 10 has a disk shape, although not particularly limited, the diameter of the main surface of the target material 10, preferably, the diameter of the sputter surface 10s is preferably 75 mm or more, more preferably 80 mm or more, further preferably 90 mm or more, still more preferably 100 mm or more, and particularly preferably 200 mm or more. The area of the main surface of the target material 10, preferably, the area of the sputter surface 10s is preferably 4500 mm$^2$ or more, more preferably 5000 mm$^2$ or more, further preferably 6000 mm$^2$ or more, still more preferably 7500 mm$^2$ or more, and particularly preferably 15000 mm$^2$ or more.

The target material 10 may have a plate shape where the main surface has a rectangular shape, and the length of the main surface of the target material 10 in the long side direction, preferably, the length of the sputter surface 10s in the long side direction is preferably 80 mm or more, more preferably 100 mm or more, further preferably 120 mm or more, still more preferably 150 mm or more, and particularly preferably 200 mm or more. The length of the main surface of the target material 10 in the short side direction, preferably, the length of the sputter surface 10s in the short side direction is preferably 50 mm or more, more preferably 80 mm or more, and further preferably 100 mm or more. The area of the main surface of the target material 10, preferably, the area of the sputter surface 10s is preferably 4500 mm$^2$ or more, more preferably 5000 mm$^2$ or more, further preferably 6000 mm$^2$ or more, still more preferably 7500 mm$^2$ or more, and particularly preferably 15000 mm$^2$ or more.

Although not particularly limited, the thickness of the target material 10 is preferably 3.0 mm or more, more preferably 5.0 mm or more, and further preferably 7.5 mm or more, and is preferably 25 mm or less, more preferably 20 mm or less, and further preferably 15 mm or less.

The backing plate (cooling plate) comprises a conductive material, such as metal or an alloy of the metal. Examples of the conductive material include Cu, Cu-alloy, Al, Al-alloy, Ti, and stainless steel (SUS). The size of the cooling plate is not particularly limited as long as the cooling plate allows joining of the target material 10, can support the target material 10, and can be mounted on a sputtering apparatus. However, the size of the cooling plate is preferably substantially equal to the size of the joint surface of the target material 10, and is preferably larger than the size of the joint surface of the target material 10.

Although the detailed description will be made later, in producing the target material 10, raw material powder (hereinafter referred to as "KNN raw material powder") can be prepared with a method in which various raw material powders containing K, Na, and Nb are mixed, and are preferably subjected to calcination, comminution, and the like. From the viewpoint of homogeneity of powder, the KNN raw material powder is preferably an oxide containing K, Na, and Nb in a solid-solution state. In the present aspect, so-called spark plasma sintering (hereinafter also simply referred to as "SPS") is performed in which a mechanical pressure is applied to a predetermined amount of KNN raw material powder to form a green compact and, at the same time, this green compact is heated by pulse energization, thus being sintered.

In performing this sintering process, in the present aspect, first, the green compact is heated by pulse energization such that a heating temperature is 450 °C or more under a relatively low mechanical pressure to discharge residual gas and the like from the green compact (hereinafter this process is also referred to as "degassing" or "low pressure SPS"). Thereafter, the green compact subjected to the degassing is heated by pulse energization under a relatively high mechanical pressure equal to or more than a pressure necessary to advance a sintering reaction to sinter the green compact (hereinafter this process is also referred to as "main SPS").

The target material 10 according to the present aspect is sintered by a novel method in which the low pressure SPS is performed and, thereafter, the main SPS is performed. Accordingly, the target material 10 has not only a high relative density, but also novel characteristics that are not exhibited in a target material sintered by performing main SPS without performing low pressure SPS, or in a target material sintered by using a so-called hot press method. To be more specific, the target material 10 according to the present aspect has at least any one of characteristics 1 to 13 described later. As a result, the target material 10 according to the present aspect further has at least any one of characteristics 14 to 17 relating to mechanical strength, and the like. A relative density of the target material 10 (hereinafter, also simply referred to as "relative density") according to the present aspect is, across the entire sputter surface, 80 % or more, preferably 85 % or more, more preferably 90 % or more, further preferably 95 % or more, and particularly preferably 98 % or more. The relative density (%) used herein refers to a value calculated by (measured density/theoretical density of KNN) $\times$ 100. For example, in KNN with (K/(Na + K)) of 0.35, the theoretical density of KNN is 4.52 g/cm$^3$.

The target material 10 according to the present aspect comprises crystal grains having a number-average grain size (hereinafter may be referred to as "Nd") of, for example, 0.10 $\mu$m or more and 20 $\mu$m or less, preferably 0.15 $\mu$m or more and 10 $\mu$m or less, further preferably 0.20 $\mu$m or more and 5.0 $\mu$m or less, and particularly preferably 0.25 $\mu$m or more and 1.5 $\mu$m or less, the number-average grain size being observed on a cross section parallel to the sputter surface 10s. The target material 10 according to the present aspect comprises crystal grains having an area-average grain size (hereinafter may be referred to as "Nv") of, for example, 0.10 $\mu$m or more and 20 $\mu$m or less, preferably 0.20 $\mu$m or more and 10 $\mu$m or less, further preferably 0.30 $\mu$m or more and 5.0 $\mu$m or less, and particularly preferably 0.45 $\mu$m or more and 2.0 $\mu$m or less, the area-average grain size being observed on the cross section parallel to the sputter surface 10s. When each of the number-average grain size and the area-average grain size of the target material 10 is within the above-mentioned range, a mechanical strength of the target material 10 can be easily increased. The number-average grain size and the area-average grain size of the target material 10 according to the present aspect will be described later. The number-average grain size and the area-average grain size of the target material 10 according to the present aspect has substantially the same value for both of the case where heat treatment in an oxygen-containing atmosphere or in air (hereinafter may be referred to as "oxidation treatment") is omitted in a production process described later and the case where the oxidation treatment is performed in the production process.

Hereinafter, various novel characteristics that the target material 10 of the present aspect may have will be described.

(Characteristic 1)

One of the characteristics that the target material 10 may have is that,
in a plurality of crystal grains of an alkali niobium oxide observed on the sputter surface 10s, the number-average grain size Nd ($\mu$m) and the area-average grain size Nv ($\mu$m) satisfy a relationship formula of (Nv - Nd)/Nd $\leq$ 2.1.

This characteristic may be exhibited in either of the case where the oxidation treatment is omitted in the production process described later and the case where the oxidation treatment is performed in the production process.

Preferably, the number-average grain size Nd ($\mu$m) and the area-average grain size Nv ($\mu$m) can be obtained by, for example, analyzing an electron back scattered diffraction pattern (EBSD) image of the sputter surface 10s of the target material 10. A crystal grain size obtained by EBSD analysis is represented by the diameter of a circle having the same area as the measured crystal grain. For the number-average grain size Nd ($\mu$m), an average grain size obtained by the Number method in the EBSD measurement can be adopted. In the Number method, the value obtained by dividing the entire area of an analysis object by the number of crystal grains is the average area of crystal grains, and the diameter of the equivalent circle for the area calculated by [measurement region ($\mu$m$^2$)/the number of crystals] is an average grain size. In the case where crystal orientation analysis software OIM manufactured by TSL SOLUTIONS, K.K. is used for the analysis, when a large number of voids, defects, or the like are observed in a region of the target material 10 to be evaluated, regions where a confidence index (CI value) defined by the OIM is equal to or less than a predetermined value are eliminated, and a crystal grain size is calculated from the value obtained from [(measurement region - region where CI value is equal to or less than predetermined value)/the number of crystals]. Accordingly, an average grain size can be calculated with higher accuracy. On the other hand, for the area-average grain size Nv ($\mu$m), an average grain size obtained by the Area Fraction method can be adopted. In the Area Fraction method, the total value of values obtained by taking the ratio of the areas of respective crystal grains to the entire area, and by multiplying the ratio by respective area values is the average area of the crystal grains, and the diameter of the equivalent circle for the calculated area is an average grain size. In EBSD analysis, boundaries with a crystal orientation difference of a certain value or more, for example, 15° or more, are assumed to be crystal grain boundaries, thus allowing the number-average grain size Nd ($\mu$m) and the area-average grain size Nv ($\mu$m) to be obtained.

For the number-average grain size Nd ($\mu$m) and the area-average grain size Nv ($\mu$m), values calculated by using the following formulae may be adopted, respectively. In the following formulae, "$d_i$" denotes the grain size ($\mu$m) of an observed crystal grain, and "ni" denotes the number of crystal grains having the observed grain size $d_i$ ($\mu$m). In the following formulae, "$d_i$" denotes the diameter of a true circle having an area equal to the area of the observed crystal grain, that is, an equivalent circle diameter ($\mu$m).

$$\text{The number-average grain size Nd } (\mu m) = \Sigma(d_i \times n_i)/\Sigma n_i$$

$$\text{The area-average grain size Nv } (\mu m) = \Sigma(d_i^3 \times n_i)/\Sigma(d_i^2 \times n_i)$$

The area-average grain size Nv ($\mu$m) is an average value weighted according to the size of a crystal grain area. In the case where some crystal grains grow larger than other crystal grains, the area-average grain size Nv ($\mu$m) becomes larger than the number-average grain size Nd ($\mu$m). That is, a difference between the area-average grain size Nv ($\mu$m) and the number-average grain size Nd ($\mu$m) increases and, as a result, the value of (Nv - Nd)/Nd increases.

In the production process of the target material 10 according to the present aspect, the novel method is adopted in which the low pressure SPS is performed and, thereafter, the main SPS is performed. Accordingly, compared with the case where sintering is performed by the main SPS without performing the low pressure SPS, or the case where sintering is performed by using a hot press method, a large variation in size of crystal grains, that is, growth of some crystal grains to sizes significantly larger than that of other crystal grains, can be suppressed. As a result, the target material 10 according to the present aspect can obtain the characteristic described above. In the case where sintering is performed by the main SPS without performing the low pressure SPS, or the case where sintering is performed by using a hot press method, there is a large variation in size of crystal grains, so that the characteristic described above cannot be obtained.

(Characteristic 2)

One of the characteristics that the target material 10 may have is that, in a plurality of crystal grains observed on the sputter surface 10s, the area-average grain size Nv ($\mu$m) and an area-average standard deviation Ns ($\mu$m) satisfy a relationship formula of Ns/Nv $\leq$ 0.76.

This characteristic may be exhibited in either of the case where the oxidation treatment is omitted in the production process described later and the case where the oxidation treatment is performed in the production process.

A method for calculating the area-average grain size Nv ($\mu$m) is as described above. The area-average standard deviation Ns ($\mu$m) is calculated from distribution of crystal grain sizes of respective crystals (the diameters of equivalent circles for the crystal areas). When the grain size of the respective crystals obtained in calculating the above-mentioned area-average grain size is taken as $D_i$, the area-average standard deviation Ns ($\mu$m) is calculated by using the following formula.

$$\text{The area-average standard deviation Ns } (\mu m) = [\{\Sigma(D_i - Nv)^2\}/\Sigma n_i]^{1/2}$$

In the production process of the target material 10 according to the present aspect, the novel method is adopted in which the low pressure SPS is performed and, thereafter, the main SPS is performed. Accordingly, compared with the case where sintering is performed by the main SPS without performing the low pressure SPS, or the case where sintering is performed by using a hot press method, a large variation in size of crystal grains, that is, growth of some crystal grains to sizes significantly larger than that of other crystal grains, can be suppressed. As a result, the target material 10 according to the present aspect can obtain the characteristic described above. In the case where sintering is performed by the main SPS without performing the low pressure SPS, or the case where sintering is performed by using a hot press method, there is a large variation in size of crystal grains, so that the characteristic described above cannot be obtained.

(Characteristic 3)

One of the characteristics that the target material 10 may have is that
when the sputter surface 10s is observed by an EBSD method from the normal direction of the sputter surface 10s, and the area of an observation region on the sputter surface 10s is defined as 1, an area ratio $A_{<103>}$ of crystal grains with $<103>_{0-10°}$ orientation, that is, the area ratio $A_{<103>}$ per unit area of the sputter surface 10s is 0.061 or more.

This characteristic may be exhibited in either of the case where the oxidation treatment is omitted in the production process described later and the case where the oxidation treatment is performed in the production process.

In this description, a crystal grain with $<103>_{0-10°}$ orientation refers to, of crystal grains observed when crystal orientation on the sputter surface 10s is measured by an EBSD method, a crystal grain with a plane for which misorientation between (an angle formed by) $<103>$ orientation and the normal direction of the sputter surface 10s is within the range of 0° or more and 10° or less. In respective characteristics described later, the description made in this paragraph is also applicable to crystal planes with other orientations, that is, to a crystal plane with any of $<101>_{0-10°}$ orientation, $<010>_{0-10°}$ orientation, $<111>_{0-10°}$ orientation, $<212>_{0-10°}$ orientation, or $<121>_{0-10°}$ orientation.

In the production process of the target material 10 according to the present aspect, the novel method is adopted in which the low pressure SPS is performed and, thereafter, the main SPS is performed and hence, the characteristic described above can be obtained. In the case where sintering is performed by the main SPS without performing the low pressure SPS, or the case where sintering is performed by using a hot press method, the characteristic described above cannot be obtained.

(Characteristic 4)

One of the characteristics that the target material 10 may have is that

when the sputter surface 10s is observed by an EBSD method from the normal direction of the sputter surface, and the area of an observation region on the sputter surface 10s is defined as 1,
when a total area ratio of crystal grains with $<101>_{0-10°}$ orientation, crystal grains with $<010>_{0-10°}$ orientation, crystal grains with $<111>_{0-10°}$ orientation, crystal grains with $<103>_{0-10°}$ orientation, crystal grains with $<212>_{0-10°}$ orientation, and crystal grains with $<121>_{0-10°}$ orientation is defined as A, and
when an area ratio of the crystal grain with $<103>_{0-10°}$ orientation is defined as $A_{<103>}$,
a ratio of the $A_{<103>}$ to the A, that is, $A_{<103>}/A$, is 0.165 or more.

This characteristic may be exhibited in either of the case where the oxidation treatment is omitted in the production process described later and the case where the oxidation treatment is performed in the production process.

In the production process of the target material 10 according to the present aspect, the novel method is adopted in which the low pressure SPS is performed and, thereafter, the main SPS is performed and hence, the characteristic described above can be obtained. In the case where sintering is performed by the main SPS without performing the low pressure SPS, or the case where sintering is performed by using a hot press method, the characteristic described above cannot be obtained.

(Characteristic 5)

One of the characteristics that the target material 10 may have is that

when the sputter surface 10s is observed by an EBSD method from the normal direction of the sputter surface, and the area of an observation region on the sputter surface 10s is defined as 1, and

when a total area ratio of crystal grains with $<212>_{0\text{-}10°}$ orientation and crystal grains with $<121>_{0\text{-}10°}$ orientation is defined as $A_{<212>+<121>}$,

a ratio of the $A_{<212>+<121>}$ to the A described above, that is, $A_{<212>+<121>}/A$, is 0.580 or less.

This characteristic may be exhibited in either of the case where the oxidation treatment is omitted in the production process described later and the case where the oxidation treatment is performed in the production process.

In the production process of the target material 10 according to the present aspect, the novel method is adopted in which the low pressure SPS is performed and, thereafter, the main SPS is performed and hence, the characteristic described above can be obtained. In the case where sintering is performed by the main SPS without performing the low pressure SPS, or the case where sintering is performed by using a hot press method, the characteristic described above cannot be obtained.

(Characteristic 6)

One of the characteristics that the target material 10 may have is that

when the sputter surface 10s is observed by an EBSD method from the normal direction of the sputter surface, and the area of an observation region on the sputter surface 10s is defined as 1, and

when an area ratio of crystal grains with $<101>_{0\text{-}10°}$ orientation is defined as $A_{<101>}$,

a ratio of the $A_{<101>}$ to the A described above, that is, $A_{<101>}/A$, is less than 0.130.

This characteristic may be exhibited in either of the case where the oxidation treatment is omitted in the production process described later and the case where the oxidation treatment is performed in the production process.

(Characteristic 7)

One of the characteristics that the target material 10 may have is that when the area of an observation region on the sputter surface 10s observed by an EBSD method is defined as 1, the total area ratio A described above, that is, the total area ratio A per unit area of the sputter surface 10s, is 0.40 or more.

This characteristic may be exhibited in either of the case where the oxidation treatment is omitted in the production process described later and the case where the oxidation treatment is performed in the production process.

In the production process of the target material 10 according to the present aspect, the novel method is adopted in which the low pressure SPS is performed and, thereafter, the main SPS is performed and hence, the characteristic described above can be obtained. In the case where sintering is performed by the main SPS without performing the low pressure SPS, or the case where sintering is performed by using a hot press method, the characteristic described above cannot be obtained.

(Characteristic 8)

One of the characteristics that the target material 10 may have is that a carbon concentration of the target material 10 when a volume resistivity thereof at 25 °C is less than $6.0 \times 10^{11}$ $\Omega$·cm is 200 ppm or less. Hereinafter, a carbon concentration of the target material 10 is also simply referred to as "carbon concentration", and a volume resistivity of the target material 10 is also simply referred to as "volume resistivity".

This characteristic may be exhibited in the case where the oxidation treatment is omitted in the production process described later. The concentration of carbon contained in the target material 10 (or KNN sintered ceramics) can be obtained by a combustion-infrared absorption method.

In the production process of the target material 10 according to the present aspect, the novel method is adopted in which the low pressure SPS is performed and, thereafter, the main SPS is performed. Consequently, compared with the case where sintering is performed by the main SPS without performing the low pressure SPS, or the case where sintering is performed by using a hot press method, carbon-containing gas and the like can be desorbed from a green compact being the sintering object and hence, the characteristic described above can be obtained. In the case where sintering is performed by the main SPS without performing the low pressure SPS, or the case where sintering is performed by using a hot press method, the characteristic described above cannot be obtained.

(Characteristic 9)

One of the characteristics that the target material 10 may have is that

a carbon concentration of the target material 10 when a volume resistivity thereof at 25 °C is $6.0 \times 10^{11}$ $\Omega \cdot$cm or more is 90 ppm or less.

This characteristic may be exhibited in the case where the oxidation treatment is performed in the production process described later.

In the production process of the target material 10 according to the present aspect, the novel method is adopted in which the low pressure SPS is performed and, thereafter, the main SPS is performed. Consequently, compared with the case where sintering is performed by the main SPS without performing the low pressure SPS, or the case where sintering is performed by using a hot press method, carbon-containing gas and the like can be desorbed from a green compact being the sintering object and hence, the characteristic described above can be obtained. In the case where sintering is performed by the main SPS without performing the low pressure SPS, or the case where sintering is performed by using a hot press method, the characteristic described above cannot be obtained.

(Characteristic 10)

One of the characteristics that the target material 10 may have is that
a content of carbon component (an amount of carbon component contained) in the target material when a volume resistivity at 25 °C is less than $6.0 \times 10^{11}$ $\Omega \cdot$cm is $5.0 \times 10^{-9}$ mol or less (i.e., $5.0 \times 10^{-9}$ mol/mg or less) in total as converted to carbon dioxide and carbon monoxide, per 1 mg in mass of the target material 10.

This characteristic may be exhibited in the case where the oxidation treatment is omitted in the production process described later. The content of the carbon component in the target material 10 (or KNN sintered ceramics) can be obtained by using a thermal desorption spectroscopy (TDS analysis).

Not all of the carbon component contained in the target material 10 (or KNN sintered ceramics) is desorbed as carbon dioxide or carbon monoxide in the thermal desorption spectroscopy. For example, there may be cases where the carbon component maintains a state of being incorporated in the target material 10, and is not desorbed. In view of the above, in the present aspect, it is assumed that the content of the carbon component in the target material 10 (or KNN sintered ceramics) refers to a total value of the carbon component that can be quantified as carbon dioxide and carbon monoxide desorbed when the target material 10 (or KNN sintered ceramics) is heated to 700 °C to 1000 °C.

In the production process of the target material 10 according to the present aspect, the novel method is adopted in which the low pressure SPS is performed and, thereafter, the main SPS is performed. Consequently, compared with the case where sintering is performed by the main SPS without performing the low pressure SPS, or the case where sintering is performed by using a hot press method, carbon-containing gas and the like can be desorbed from a green compact being the sintering object and hence, the characteristic described above can be obtained. In the case where sintering is performed by the main SPS without performing the low pressure SPS, or the case where sintering is performed by using a hot press method, the characteristic described above cannot be obtained.

(Characteristic 11)

One of the characteristics that the target material 10 may have is that
a content of carbon component in the target material when a volume resistivity at 25 °C is $6.0 \times 10^{11}$ $\Omega \cdot$cm or more is $4.0 \times 10^{-9}$ mol or less (i.e., $4.0 \times 10^{-9}$ mol/mg or less) in total as converted to carbon dioxide and carbon monoxide, per 1 mg in mass of the target material 10.

This characteristic may be exhibited in the case where the oxidation treatment is performed in the production process described later.

Not all of the carbon component contained in the target material 10 (or KNN sintered ceramics) is desorbed as carbon dioxide or carbon monoxide in the thermal desorption spectroscopy. For example, there may be cases where the carbon component maintains a state of being incorporated in the target material 10, and is not desorbed. In view of the above, in the present aspect, it is assumed that the content of the carbon component in the target material 10 (or KNN sintered ceramics) refers to a total value of the carbon component that can be quantified as carbon dioxide and carbon monoxide desorbed when the target material 10 (or KNN sintered ceramics) is heated to 700 °C to 1000 °C.

In the production process of the target material 10 according to the present aspect, the novel method is adopted in which the low pressure SPS is performed and, thereafter, the main SPS is performed. Consequently, compared with the case where sintering is performed by the main SPS without performing the low pressure SPS, or the case where sintering is performed by using a hot press method, carbon-containing gas and the like can be desorbed from a green compact being the sintering object and hence, the characteristic described above can be obtained. In the case where sintering is performed by the main SPS without performing the low pressure SPS, or the case where sintering is performed by using a hot press method, the characteristic described above cannot be obtained.

(Characteristic 12)

One of the characteristics that the target material 10 may have is that

Sv/S × 100 [%] being a ratio of a total area Sv of voids present on an observation field of view to an observation area S on the sputter surface 10s, that is, a ratio (hereinafter also referred to as "void ratio") of the Sv per unit area of the sputter surface 10s, is 12.0 % or less, and
an average diameter of voids present on the sputter surface 10s is 0.60 $\mu$m or less.

This characteristic may be exhibited in the case where the oxidation treatment is performed in the production process described later.
Voids appear on the sputter surface 10s due to voids or the like generated in the target material 10, and are observed on the sputter surface 10s as openings of recessed spaces. The total area of the voids present on the sputter surface 10s and the average diameter of the voids can be calculated by, for example, analyzing an optical microscope image or a scanning electron microscope (hereinafter may be referred to as "SEM") image of the sputter surface 10s by image analysis software. The total area of the voids means the total value of plane areas (cross-sectional areas) of the openings, and is obtained by calculating the total area of void portions by the image analysis. By calculating the ratio of the total area of the void portions to the measurement area, the ratio of the total area of the voids can be obtained. The average diameter of voids refers to the average value of equivalent circle diameters ($\mu$m) of a plurality of voids observed in an arbitrary observation field of view on the sputter surface 10s, and this value is substantially equal to the average diameter of voids present on the sputter surface 10s. The average diameter of voids may be represented by, for example, an equivalent circle diameter obtained with the method in which the areas of respective voids are calculated by the image analysis, all of the areas are summed to obtain the total area, and the equivalent circle diameter (50 % average area diameter) is calculated from the area at 50 % of the cumulative area with respect to the total area.
In the production process of the target material 10 according to the present aspect, the novel method is adopted in which the low pressure SPS is performed and, thereafter, the main SPS is performed. Consequently, compared with the case where sintering is performed by the main SPS without performing the low pressure SPS, or the case where sintering is performed by using a hot press method, the appearance of voids on the sputter surface 10s can be suppressed, and voids can be reduced to a minute size and hence, the characteristic described above can be obtained. In the case where sintering is performed by the main SPS without performing the low pressure SPS, or the case where sintering is performed by using a hot press method, the characteristics described above cannot be obtained for at least one of either the void ratio or the average diameter of voids.

(Characteristic 13)

One of the characteristics that the target material 10 may have is that
a maximum diameter of a void present on the sputter surface 10s is 1.0 $\mu$m or less.
This characteristic may be exhibited in the case where the oxidation treatment is performed in the production process described later.
The maximum diameter of a void refers to an equivalent circle diameter ($\mu$m) of a void having the maximum size of a plurality of voids observed in an arbitrary observation field of view on the sputter surface 10s, and this value is substantially equal to a maximum diameter of a void on the sputter surface 10s. In the production process of the target material 10 according to the present aspect, the novel method is adopted in which the low pressure SPS is performed and, thereafter, the main SPS is performed. Consequently, compared with the case where sintering is performed by the main SPS without performing the low pressure SPS, or the case where sintering is performed by using a hot press method, voids can be reduced to a minute size and hence, the characteristic described above can be obtained. In the case where sintering is performed by the main SPS without performing the low pressure SPS, or the case where sintering is performed by using a hot press method, the characteristic described above cannot be obtained.

(Characteristic 14)

One of the characteristics that the target material 10 may have is that
when a volume resistivity at 25 °C is less than $6.0 \times 10^{11}$ $\Omega$·cm, a Vickers hardness of the target material 10 (hereinafter, also simply referred to as "Vickers hardness") is 460 or more, and a flexural strength of the target material 10 (hereinafter, also simply referred to as "flexural strength ") is 90 MPa or more.
This characteristic may be exhibited in the case where the oxidation treatment is omitted in the production process described later. The Vickers hardness (Hv) of the target material 10 (or KNN sintered ceramics) conforms to JIS R 1610: 2003, can be measured with a Vickers hardness meter, and can be measured by, for example, a method described in Example. The flexural strength of the target material 10 (or KNN sintered ceramics) conforms to JIS R 1601: 2008, can be obtained by a three-point bending test, and can be measured by, for example, a method described in Example.

In the production process of the target material 10 according to the present aspect, the novel method is adopted in which the low pressure SPS is performed and, thereafter, the main SPS is performed and hence, at least any one of the characteristics 1 to 13 described above can be obtained. As a result, the Vickers hardness of the target material 10 can be increased, and the flexural strength of the target material 10 can also be increased. In the case where sintering is performed by the main SPS without performing the low pressure SPS, or the case where sintering is performed by using a hot press method, the characteristics 1 to 13 described above are not exhibited, and hence, in the case where the oxidation treatment is omitted (the case where the volume resistivity at 25 °C is less than $6.0 \times 10^{11}$ Ω·cm), the characteristics described above cannot be obtained for at least one of either the Vickers hardness or the flexural strength.

(Characteristic 15)

One of the characteristics that the target material 10 may have is that
when a volume resistivity at 25 °C is $6.0 \times 10^{11}$ Ω·cm or more, a Vickers hardness of the target material 10 is 250 or more, and a flexural strength thereof is 90 MPa or more.

This characteristic may be exhibited in the case where the oxidation treatment is performed in the production process described later.

In the production process of the target material 10 according to the present aspect, the novel method is adopted in which the low pressure SPS is performed and, thereafter, the main SPS is performed and hence, at least any one of the characteristics 1 to 13 described above can be obtained. As a result, the Vickers hardness of the target material 10 can be increased, and the flexural strength of the target material 10 can also be increased. In the case where sintering is performed by the main SPS without performing the low pressure SPS, or the case where sintering is performed by using a hot press method, the characteristics 1 to 13 described above are not exhibited, and hence, in the case where the oxidation treatment is performed (the case where the volume resistivity at 25 °C is $6.0 \times 10^{11}$ Ω·cm or more), the characteristics described above cannot be obtained for at least one of either the Vickers hardness or the flexural strength.

(Characteristic 16)

One of the characteristics that the target material 10 may have is that
a Vickers hardness of the target material 10 after heat treatment at 900 °C for 5 hours in air is maintained at a magnitude exceeding 50 % of a Vickers hardness thereof before the heat treatment.

This characteristic may be exhibited in either of the case where the oxidation treatment is omitted in the production process described later and the case where the oxidation treatment is performed in the production process.

In the production process of the target material 10 according to the present aspect, the novel method is adopted in which the low pressure SPS is performed and, thereafter, the main SPS is performed and hence, at least any one of the characteristics 1 to 13 described above can be obtained and, as a result, the characteristics described above for the Vickers hardness before the heat treatment and the Vickers hardness after the heat treatment can be obtained. In the case where sintering is performed by the main SPS without performing the low pressure SPS, or the case where sintering is performed by using a hot press method, the characteristics 1 to 13 described above are not exhibited and hence, the characteristic described above cannot be obtained.

(Characteristic 17)

One of the characteristics that the target material 10 may have is that
a relative density of the target material after heat treatment at 900 °C for 5 hours in air is maintained at a magnitude exceeding 95 % of the relative density thereof before the heat treatment.

This characteristic may be exhibited in either of the case where the oxidation treatment is omitted in the production process described later and the case where the oxidation treatment is performed in the production process.

In the production process of the target material 10 according to the present aspect, the novel method is adopted in which the low pressure SPS is performed and, thereafter, the main SPS is performed and hence, at least any one of the characteristics 1 to 13 described above can be obtained and, as a result, the characteristics described above for the relative density before the heat treatment and the relative density after heat treatment can be obtained. In the case where sintering is performed by the main SPS without performing the low pressure SPS, or the case where sintering is performed by using a hot press method, the characteristics 1 to 13 described above are not exhibited and hence, the characteristic described above cannot be obtained.

(2) Method for producing target material

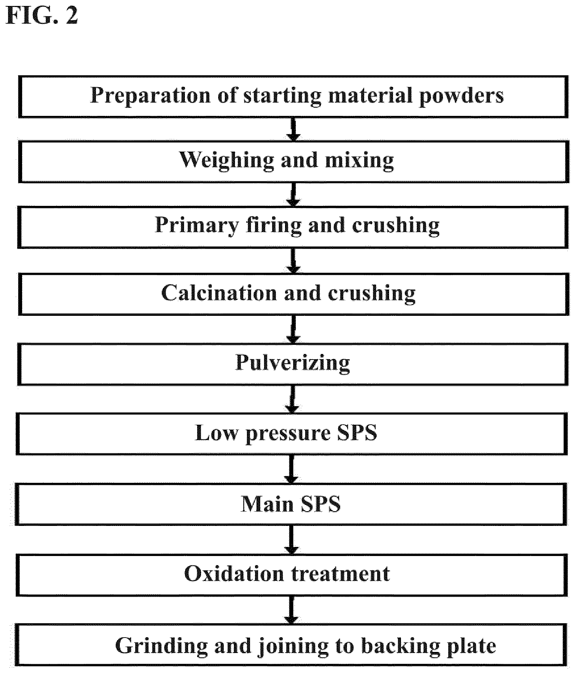

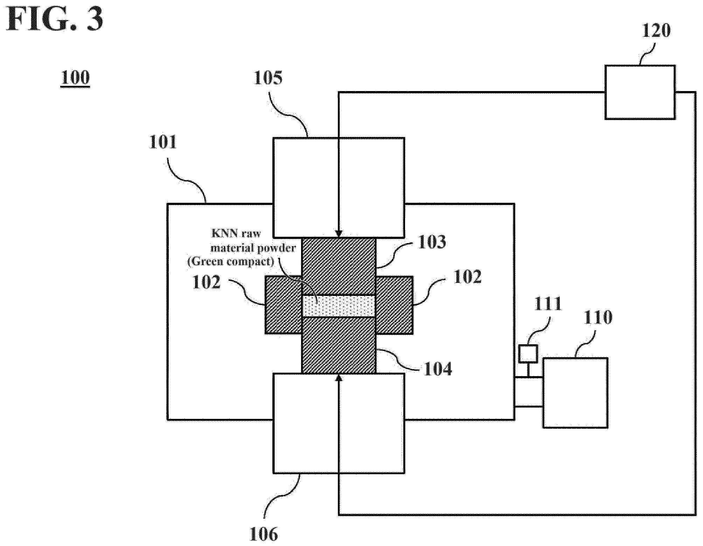

A preferred embodiment of a method for producing the target material 10 according to the present aspect will be described in detail with reference to FIG. 2 and FIG. 3.

(Preparation of starting material powders)

First, powder containing K, powder containing Na, and powder containing Nb, for example, potassium carbonate ($K_2CO_3$) powder, sodium carbonate ($Na_2CO_3$) powder, and niobium pentaoxide ($Nb_2O_5$) powder, are prepared as starting material powders.

The "powder comprising a compound of K" refers to powder comprising a compound of K as a main component, and may include not only the case of comprising only powder of the compound of K, but also the case of comprising powder of another compound in addition to powder of the compound of K as the main component. Similarly, "powder comprising a compound of Na" refers to powder comprising a compound of Na as a main component, and may include not only the case of comprising only powder of the compound of Na, but also the case of comprising powder of another compound in addition to powder of the compound of Na as the main component. Further, "powder comprising a compound of Nb" refers to powder comprising a compound of Nb as a main component, and may include not only the case of comprising only powder of the compound of Nb, but also the case of comprising powder of another compound in addition to powder of the compound of Nb as the main component. The compound of K refers to at least one compound selected from the group consisting of an oxide of K, a composite oxide of K, and a compound of K that becomes an oxide by heating. Examples of the compound of K include the above-mentioned carbonate, and an oxalate. The compound of Na refers to at least one compound selected from the group consisting of an oxide of Na, a composite oxide of Na, and a compound of Na that becomes an oxide by heating. Examples of the compound of Na include the above-mentioned carbonate, and an oxalate. The compound of Nb refers to at least one compound selected from the group consisting of an oxide of Nb, a composite oxide of Nb, and a compound of Nb that becomes an oxide by heating. An example of the compound of Nb includes the above-mentioned niobium pentaoxide.

Powders containing at least one dopant element selected from the group consisting of Li, Mg, Ca, Sr, Ba, Bi, Sb, V, In, Ta, Mo, W, Cr, Ti, Zr, Hf, Sc, Y, La, Ce, Pr, Nd, Sm, Eu, Gd, Tb, Dy, Ho, Er, Tm, Yb, Lu, Cu, Zn, Ag, Mn, Fe, Co, Ni, Al, Si, Ge, Sn, and Ga are prepared as the starting material powders as necessary. For example, powder of the single element, oxide powder containing the element, composite oxide powder containing the element, and powder of a compound containing the element that becomes an oxide by heating (carbonate, oxalate, for example) are prepared as the powder containing the above-mentioned dopant element.

It is preferable that average particle diameters of these starting material powders be, for example, less than 1 mm in terms of median diameter $D_{50}$, and it is preferable to crush the starting material powders in advance before weighing, as necessary.

(Weighing and mixing)

Subsequently, the respective starting material powders are weighed, and a mixing ratio of the starting material powders is adjusted such that the composition of the target material 10 to be obtained at the final stage achieves a desired composition. Weighing may be performed in air. However, it is preferable to perform the weighing in an atmosphere with a low humidity, such as in an inert gas atmosphere, in vacuum, or in dry air atmosphere. It is also preferable to perform the weighing after the respective starting material powders are sufficiently dried. Then, the weighed starting material powders are dry-mixed by a mixer, such as a henschel mixer, a blender, a ribbon mixer, a super mixer, a nauta mixer, an intensive mixer, or an automatic mortar.

(Primary firing and crushing)

The obtained mixed powder is primarily fired by an electric furnace or other furnaces in an oxidizing atmosphere, such as in air or in an oxygen gas atmosphere, thus obtaining a fired material containing K, Na, and Nb. It is preferable that the mixed powder of raw materials be subjected to solid phase reaction in the primary firing, thus obtaining a fired material in which K, Na, and Nb are in a solid-solution state. Thereafter, the obtained fired material is crushed by a comminuting means, such as a ball mill, a bead mill, a vibration mill, an attritor, a jet mill, an atomizer, or a cutter mill, thus obtaining fired powder (hereinafter referred to as "KNN fired powder"). In the case where K, Na, and Nb are brought into a solid-solution state in the primary firing, KNN fired powder in which K, Na, and Nb are in a solid-solution state (hereinafter referred to as "KNN solid solution powder") can be obtained.

A heating temperature for the primary firing is preferably 500 °C or more, more preferably 550 °C or more, and further preferably 600 °C or more, and is preferably 750 °C or less, and more preferably 700 °C or less. When the heating temperature is equal to or more than the above-mentioned lower limit, KNN solid solution powder in which K, Na, and Nb are in a solid-solution state can be easily obtained, and fired powder with high homogeneity can be easily obtained. When the heating temperature is equal to or less than the above-mentioned upper limit, a BET specific surface areas of KNN fired powder and KNN solid solution powder can be easily increased, and fired powder with high sinterability can be easily obtained.

Although not particularly limited, a time period for the primary firing is preferably 3 hours or more and 20 hours or less, more preferably 4 hours or more and 15 hours or less, and further preferably 5 hours or more and 10 hours or less.

(Calcination and crushing)

The obtained KNN fired powder (or KNN solid solution powder) is further calcined in an oxidizing atmosphere, such as in air or in an oxygen gas atmosphere and, thereafter, is crushed by a comminuting means, such as a ball mill, a bead mill, a vibration mill, an attritor, a jet mill, or an atomizer, thus obtaining KNN calcined powder. By performing the calcination, impurities, such as moisture, a carbon component, and a chlorine, can be removed from the KNN calcined powder, so that KNN calcined powder with high purity can be obtained.

A heating temperature for the calcination is preferably 500 °C or more, more preferably 600 °C or more, further preferably 650 °C or more, and particularly preferably 700 °C or more, and is preferably 1150 °C or less, more preferably 1100 °C or less, and further preferably 1000 °C or less. When the heating temperature is equal to or more than the above-mentioned lower limit, KNN calcined powder with high purity can be easily obtained. When the heating temperature is equal to or less than the above-mentioned upper limit, KNN raw material powder with a large BET specific surface area and high sinterability can be easily obtained.

Although not particularly limited, a heating time period for the calcination is preferably 3 hours or more and 50 hours or less, more preferably 3.5 hours or more and 30 hours or less, further preferably 4 hours or more and 20 hours or less, and particularly preferably 5 hours or more and 12 hours or less.

From the viewpoint of easily removing impurities, in the calcination process, heat treatment may be performed in multiple stages at different heating temperatures.

(Pulverizing)

The KNN calcined powder obtained by crushing is further comminuted by a comminuting means, such as a ball mill, a bead mill, a vibration mill, an attritor, an atomizer, or a jet mill, preferably by a jet mill, and is dried as necessary after the comminution, thus obtaining KNN raw material powder with predetermined specifications (specific surface area, impurity concentration, and the like).

In the case where calcined powder is comminuted by, for example, a jet mill, a processing rate is 1.0 kg/h or more and 8.0 kg/h or less, preferably 1.2 kg/h or more and 6.0 kg/h or less, and more preferably 1.5 kg/h or more and 3.0 kg/h or less. Further, an introduction pressure is 0.1 MPa or more and 2.0 MPa or less, preferably 0.5 MPa or more and 1.8 MPa or less, and more preferably 1.0 MPa or more and 1.7 MPa or less. A mill pressure is 0.1 MPa or more and 2.0 MPa or less, preferably 0.5 MPa or more and 1.8 MPa or less, and more preferably 1.0 MPa or more and 1.7 MPa or less. When calcined powder is comminuted under the above-mentioned conditions, raw material powder with a large BET specific surface area and high sinterability can be easily obtained.

The KNN raw material powder used for SPS sintering of the present aspect is obtained through the above-mentioned processes. The BET specific surface area of the KNN raw material powder is preferably 1.0 $m^2$/g or more, more preferably 2.0 $m^2$/g or more, further preferably 2.5 $m^2$/g or more, and particularly preferably 3.0 $m^2$/g or more, and is preferably 11 $m^2$/g or less, more preferably 10 $m^2$/g or less, further preferably 8.0 $m^2$/g or less, still more preferably 7.0 $m^2$/g or less, and particularly preferably 6.0 $m^2$/g or less. When the BET specific surface area of the KNN raw material powder is equal to or more than the above-mentioned lower limit value, sinterability is increased and hence a KNN sintered ceramics with high density can be easily obtained. When the BET specific surface area of the KNN raw material powder is equal to or less than the above-mentioned upper limit value, gas components (for example, gas components contained in air, carbon dioxide, carbon monoxide, methane, and the like) and moisture that adsorb to the produced raw material powder can be reduced and hence a KNN sintered ceramics containing less impurities and voids can be easily obtained. The BET specific surface area of the KNN raw material powder can be measured by a gas adsorption device, and can be obtained by a method described in Example. The obtained KNN raw material powder is used after heated and dried at 180 °C to 200 °C, for example, as necessary.

A concentration of carbon contained in the KNN raw material powder is preferably 250 ppm or less, and more preferably 200 ppm or less.

The KNN raw material powder used for the SPS sintering of the present aspect can also be obtained by mixing $KNbO_3$ powder and $NaNbO_3$ powder obtained by a so-called hydrothermal synthesis method, in which potassium hydroxide aqueous solution or sodium hydroxide aqueous solution is caused to react with $Nb_2O_5$ powder being a starting material powder in hot water of high temperature and high pressure. By causing the reaction products obtained via hydrothermal synthesis to be subjected to, for example, solid-liquid separation, washing with water, drying, and the like, oxide powder ($KNbO_3$ powder, $NaNbO_3$ powder) can be obtained. By mixing the obtained $KNbO_3$ powder and the obtained $NaNbO_3$ powder at a predetermined ratio, KNN raw material powder can be obtained.

From the viewpoint of promoting a reaction in hydrothermal synthesis, a temperature of hot water is preferably 150 °C or more, more preferably 180 °C or more, and further preferably 200 °C or more, and is preferably 350 °C or less, more preferably 300 °C or less, and further preferably 250 °C or less. A pressure of the hot water is preferably 0.1 MPa or more, more preferably 0.2 MPa or more, further preferably 0.5 MPa or more, still more preferably 1.0 MPa or more, and particularly preferably 1.5 MPa or more, and is preferably 10 MPa or less, more preferably 5 MPa or less, and further preferably 3 MPa or less.

By preparing KNN raw material powder via hydrothermal synthesis, the concentration of carbon contained in the KNN raw material powder can be further reduced. As a result, using the KNN raw material powder prepared via hydrothermal synthesis can further reduce a carbon concentration of the KNN sintered ceramics.

By performing the process described above, such as firing, on the KNN raw material powder obtained via hydrothermal synthesis, KNN raw material powder in which K, Na, and Nb are solid-dissolved (KNN solid solution powder) can be obtained. KNN raw material powder in which K, Na, and Nb are solid-dissolved can also be obtained by a method in which potassium hydroxide aqueous solution, sodium hydroxide aqueous solution, and $Nb_2O_5$ powder are mixed in advance with a desired composition, and the mixture is caused to react in hot water of high temperature and high pressure. To obtain a desired BET specific surface area, the process described above, such as firing or comminution, may also be performed on KNN raw material powder or KNN solid solution powder prepared via hydrothermal synthesis.

The process described above, such as primary firing, crushing, calcination, crushing, or jet mill comminution, may be partially or wholly repeated as necessary, and any process may be omitted as necessary. Sieving or the like may be additionally performed after the completion of these processes or between the respective processes. A means used for mixing or comminution is not limited to the means described above as the examples, and any of other various comminuting means may be adopted. In addition, conditions when other comminuting means is adopted may also be selected according to various purposes for obtaining the specifications described above.

Next, a preferred embodiment of a low pressure SPS process and a main SPS process will be described with reference to FIG. 3. FIG. 3 is a schematic configuration diagram of a sintering apparatus 100 used in these processes. The sintering apparatus 100 includes a chamber 101, a die 102, punches 103, 104, pressurizing devices 105, 106, a vacuum pump 110, a pressure gauge 111, a pulse energizing device 120, and the like.

(Low pressure SPS)

First, a predetermined amount of KNN raw material powder with the specifications described above is filled into the cylindrical die (sintering die) 102. Next, the die 102 filled with the KNN raw material powder is accommodated in the chamber 101, and is placed between the pair of upper and lower punches 103, 104. Then, the inside of the chamber 101 is evacuated with the vacuum pump 110 while monitoring the pressure in the chamber 101 by the pressure gauge 111. Although it is sufficient that the die 102 and the punches 103, 104 comprising a conductive material, they preferably comprise a carbon material, such as graphite.

When the inside of the chamber 101 reaches a desired pressure, the pressurizing devices 105, 106 are operated to apply a mechanical pressure to the KNN raw material powder, filled in the die 102, via the punches 103, 104 and, at the same time, the pulse energizing device 120 starts heating of the KNN raw material powder by pulse energization. Due to the start of the pulse energization, a temperature of a green compact obtained by pressurizing the KNN raw material powder gradually rises from a starting temperature of approximately room temperature (25 °C) to a predetermined degassing temperature described later.

This degassing temperature is 450 °C or more, and may be a temperature substantially equal to a sintering temperature in the main SPS described later. However, a mechanical pressure applied in the low pressure SPS (degassing pressure) is set to be significantly lower than a mechanical pressure in the main SPS (sintering pressure). Consequently, in the low pressure SPS, a sintering reaction of the KNN raw material powder progresses slowly in the green compact, and degassing from the green compact is easily achieved due to heating performed simultaneously.

The mechanical pressure in the low pressure SPS process may be any pressure provided that the mechanical pressure can achieve stable energization in an SPS device. However, from the viewpoint of easily discharging residual gas from the green compact, the mechanical pressure is preferably 1 MPa or more, more preferably 5 MPa or more, further preferably 7 MPa or more, and still more preferably 8 MPa or more, and is preferably 15 MPa or less, more preferably 12 MPa or less, and further preferably 10 MPa or less.

The degassing temperature in the low pressure SPS process is preferably 500 °C or more, more preferably 600 °C or more, further preferably 700 °C or more, still more preferably 800 °C or more, and particularly preferably 900 °C or more, and is preferably 1200 °C or less, and more preferably 1100 °C or less. When the degassing temperature in the low pressure SPS process is within the above-mentioned range, residual gas can be easily discharged, so that a sintered ceramics with high mechanical strength can be easily obtained.

A heating time period at the above-mentioned degassing temperature is not particularly limited. Heating may be performed for a fixed time period at the above-mentioned heating temperature or more by providing a sufficient temperature raising time period, or a state where the temperature reaches the degassing temperature may be held for a fixed time period. In the case of holding the state where the temperature reaches the degassing temperature, the holding time period is preferably 5 minutes or more, more preferably 10 minutes or more, and further preferably 20 minutes or more, and is preferably 10 hours or less, more preferably 5 hours or less, further preferably 3 hours or less, still more preferably 60 minutes or less, particularly preferably 50 minutes or less, and particularly more preferably 40 minutes or less.

In the low pressure SPS, heating is performed by pulse energization and hence, due to actions of electromagnetic energy, joule heating, discharge plasma generated between crystal grains, and the like, residual gas (for example, carbon monoxide, carbon dioxide, moisture, as well as gas molecules containing chlorine-based impurities) adsorbed on surfaces of crystal grains can be efficiently desorbed from the surfaces of the crystal grains, and can be released from the green compact. In the low pressure SPS, a sintering reaction is caused in the KNN raw material powder and, at the same time, suppression of an excessive growth of crystal grains, and efficient degassing from the green compact can be achieved and hence, voids in the green compact are reduced in size, thus allowing the green compact to be densified. That is, excess space around crystal grains contained in the green compact is reduced, thus allowing the crystal grains to be condensed at a higher density.

Although the pressure in the chamber 101 rises when release of gas from the green compact starts, the pressure in the chamber 101 decreases again after the completion of the release of gas from the green compact. Accordingly, by monitoring this change in pressure by the pressure gauge 111, completion timing for the low pressure SPS can be determined.

Other conditions for performing the low pressure SPS are exemplified below.

Temperature of green compact (starting temperature): room temperature (25 °C) to 80 °C
Atmospheric pressure (pressure in chamber): 10 Pa or less

(Main SPS)

After the release of gas from the green compact is completed, a mechanical pressure applied to the green compact is set to be higher than the mechanical pressure in the low pressure SPS while evacuation from the chamber 101, and heating by pulse energization with the pulse energizing device 120 are continued. The mechanical pressure applied in the main SPS (sintering pressure) is set to be equal to or more than a magnitude necessary to sufficiently progress the sintering reaction of the green compact.

From the viewpoint of obtaining a sintered ceramics with high density and high resistance against cracking, the mechanical pressure in the main SPS process is preferably 25 MPa or more, more preferably 30 MPa or more, and further preferably 35 MPa or more, and is preferably 70 MPa or less, more preferably 60 MPa or less, and further preferably 50 MPa or less.

From the viewpoint of obtaining a sintered ceramics with high density and high resistance against cracking, the heating temperature in the main SPS process is preferably 700 °C or more, more preferably 750 °C or more, further preferably 800 °C or more, still more preferably 850 °C or more, and particularly preferably 900 °C or more, and is preferably 1100 °C or less, more preferably 1000 °C or less, further preferably 980 °C or less, and particularly preferably 960 °C or less.

A heating time period at the above-mentioned heating temperature is not particularly limited. Heating may be performed for a fixed time period at the above-mentioned heating temperature or more by providing a sufficient temperature raising time period, or a state where the temperature reaches a predetermined heating temperature may be held for a fixed time period. In the case of holding the heating temperature for the fixed time period, the holding time period is preferably 10 minutes or more, more preferably 15 minutes or more, and further preferably 20 minutes or more, and is preferably 240 minutes or less, more preferably 180 minutes or less, and further preferably 120 minutes or less.

This process causes the green compact to be sintered, so that a sintered ceramics with high density can be obtained. In a sintering process that uses SPS, sintering can be uniformly progressed within a short time period at a low sintering temperature compared with a sintering process that uses hot press. Consequently, the grain growth of crystal grains of the sintered ceramics can be suppressed, and the densification of the sintered ceramics can be achieved.

Other condition for performing the main SPS is exemplified below.
Atmospheric pressure (pressure in chamber): 10 Pa or less

One embodiment of the low pressure SPS and the main SPS has been described above as an example. However, the SPS sintering may be performed in an inert atmosphere, for example, in an atmosphere of an inert gas, such as nitrogen, argon, helium, or hydrogen.

(Oxidation treatment)

When the low pressure SPS or the main SPS is performed, impurities, such as a carbon component, are desorbed from the green compact, but some oxygen of an oxide sintered ceramics is desorbed from the green compact. As a result, the insulating property of the target material 10 to be obtained in the final stage may be slightly reduced in some cases. For this reason, after the main SPS is performed, heat treatment may be performed as necessary on the oxide sintered ceramics in an oxygen-containing atmosphere to achieve high resistance, leading to recovery of the insulating property of the oxide sintered ceramics. By performing the oxidation treatment, impurities remaining during the SPS sintering can be further reduced.

The oxidation treatment is performed in an oxidizing atmosphere, such as in air or in an oxygen-containing atmosphere, at a heating temperature of 500 °C or more and 1100 °C or less, preferably 700 °C or more and 1050 °C or less, more preferably 800 °C or more and 1020 °C or less, and further preferably 850 °C or more and 1000 °C or less. A heating time period is 1 hour or more and 40 hours or less, preferably 2 hours or more and 20 hours or less, more preferably 3 hours or more and 10 hours or less, and further preferably 4 hours or more and 7 hours or less.

The oxidation treatment may be omitted as necessary. In the case where the oxidation treatment is omitted, the target material 10 to be obtained at the final stage has a volume resistivity of less than $6.0 \times 10^{11}$ $\Omega \cdot$cm at 25 °C, for example. In the case where the oxidation treatment is performed, the target material 10 to be obtained at the final stage has a volume resistivity of $6.0 \times 10^{11}$ $\Omega \cdot$cm or more at 25 °C, for example.

(Finishing and joining to backing plate)

Thereafter, the sintered ceramics is, as necessary, ground into a disk shape having, for example, dimensions with an area of 4500 $mm^2$ or more and a thickness of 3 mm or more, and the surface of the sintered ceramics is polished to adjust surface conditions. With such processes, the target material 10 according to the present aspect is obtained. The target material 10 is joined to the backing plate comprising Cu or the like via the joining material containing In, Sn or an alloy containing In or Sn, and is used as a sputtering target.

(3) Effect

According to the present aspect, one or a plurality of advantageous effects described later can be obtained.

(a) The target material 10 according to the present aspect is sintered by the novel method in which the low pressure SPS is performed and, thereafter, the main SPS is performed and hence, the target material 10 has at least any one of the characteristics 1 to 13 described above.

As a result, the target material 10 according to the present aspect further has at least any one of the characteristics 14 to 17 described above relating to mechanical strength and the like.

In the target material 10 having properties described in the characteristics 14, 15, cracking, chipping, or the like are less likely to occur during mechanical process, such as grinding, in producing the target material 10, as well as during a sputtering deposition using the target material 10. Further, abnormal electrical discharge originating from cracking or chipping is less likely to occur during the sputtering deposition and hence, changes in composition of or decline in properties of a sputtering film (piezoelectric thin film) to be obtained can be suppressed.

Further, in the target material 10 having properties described in the characteristics 16, 17, the Vickers hardness and the relative density are less likely to change before, during, and after the heat treatment and hence, the target material 10 can be used in a stable manner in a sputtering deposition process or other processes in which the target material 10 is increased to a high temperature.

In the case where sintering is performed by the main SPS without performing the low pressure SPS, or the case where sintering is performed by using a hot press method, none of the characteristics 1 to 13 is exhibited and, as a result, none of characteristics described in the characteristics 14 to 17 can be obtained.

(b) By suitably selecting production conditions for the target material 10 from the range of the conditions described above, (Nv - Nd)/Nd can be 2.1 or less, and can also be preferably 1.5 or less, more preferably 1.0 or less, further preferably 0.80 or less, still more preferably 0.70 or less, particularly preferably 0.60 or less, particularly more preferably 0.50 or less, and particularly further preferably 0.44 or less.

By suitably selecting production conditions for the target material 10 from the range of the conditions described above, Ns/Nv can be 0.76 or less, and can also be preferably 0.70 or less, more preferably 0.60 or less, further preferably 0.55 or less, still more preferably 0.50 or less, and particularly preferably 0.47 or less.

As a result of the above, mechanical strength properties of the target material 10 can be further improved.

To be more specific, in the case where the oxidation treatment is omitted (the case where the volume resistivity at 25 °C is less than $6.0 \times 10^{11}$ $\Omega \cdot$cm), the Vickers hardness can be 460 or more, and can also be preferably 470 or more, more preferably 480 or more, further preferably 490 or more, still more preferably 500 or more, and particularly preferably 510 or more. In addition, the flexural strength can be 90 MPa or more, and can also be preferably 100 MPa or more, more preferably 110 MPa or more, further preferably 120 MPa or more, and still more preferably 130 MPa or more.

In the case where the oxidation treatment is performed (the case where the volume resistivity at 25 °C is $6.0 \times 10^{11}$ $\Omega \cdot$cm or more), the Vickers hardness can be 210 or more, and can also be preferably 250 or more, more preferably 300 or more, further preferably 350 or more, still more preferably 400 or more, particularly preferably 450 or more, and particularly more preferably 500 or more. In addition, the flexural strength can be 90 MPa or more, and can also be preferably 100 MPa or more, more preferably 110 MPa or more, further preferably 120 MPa or more, and still more preferably 130 MPa or more.

As a result of the above, stability of the Vickers hardness and the relative density before, during, and after the heat treatment can be further improved.

To be more specific, the Vickers hardness after the heat treatment at 900 °C for 5 hours in air can be a magnitude exceeding 50 % of the Vickers hardness before the heat treatment, and can also be preferably a magnitude exceeding 70 % of, more preferably a magnitude exceeding 90 % of, more preferably a magnitude exceeding 95 % of, and more preferably a magnitude exceeding 100 % of the Vickers hardness before the heat treatment.

In addition, the relative density after the heat treatment at 900 °C for 5 hours in air can be a magnitude exceeding 95 % of the relative density before the heat treatment, and can also be preferably a magnitude exceeding 97 % of, more preferably a magnitude exceeding 99 % of, and more preferably a magnitude exceeding 100 % of the relative density before the heat treatment.

The lower limit value of (Nv - Nd)/Nd is not particularly limited. However, for example, in the case where the relative density of the target material 10 exceeds 95 %, (Nv - Nd)/Nd is 0.10 or more, preferably 0.20 or more, more preferably 0.30 or more, further preferably 0.35 or more, and particularly preferably 0.40 or more, thus allowing cracking and chipping of the target material 10 to be more surely suppressed. Accordingly, such values are preferable.

The lower limit value of Ns/Nv is not also particularly limited. However, for example, in the case where the relative density of the target material 10 exceeds 95 %, Ns/Nv is 0.10 or more, preferably 0.20 or more, more preferably 0.30 or more, still more preferably 0.35 or more, and particularly preferably 0.40 or more, thus allowing cracking and chipping of the target material 10 to be more surely suppressed. Accordingly, such values are preferable.

(c) By suitably selecting production conditions for the target material 10 from the range of the conditions described above, the $A_{<103>}$ can be 0.061 or more, and can also be preferably 0.065 or more, more preferably 0.070 or more, further preferably 0.075 or more, and particularly preferably 0.080 or more.

By suitably selecting production conditions for the target material 10 from the range of the conditions described above, the $A_{<103>}/A$ can be 0.165 or more, and can also be preferably 0.170 or more, more preferably 0.172 or more, further preferably 0.175 or more, still more preferably 0.178 or more, and particularly preferably 0.180 or more.

By suitably selecting production conditions for the target material 10 from the range of the conditions described above, the $A_{<212>+<121>}/A$ can be 0.580 or less, and can also be preferably 0.550 or less, more preferably 0.530 or less, further preferably 0.520 or less, and particularly preferably 0.500 or less.

By suitably selecting production conditions for the target material 10 from the range of the conditions described above, the $A_{<101>}/A$ can be less than 0.130, and can also be preferably 0.120 or less, more preferably 0.115 or less, and further preferably 0.110 or less.

By suitably selecting production conditions for the target material 10 from the range of the conditions described above, the A can be 0.40 or more, and can also be preferably 0.42 or more, more preferably 0.43 or more, further preferably 0.45 or more, and particularly preferably 0.46 or more.

As a result of the above, mechanical strength properties of the target material 10 can be further improved. Accordingly, even when sputtering is performed with high power, cracking and chipping of the target material 10 can be prevented and hence, productivity for production of thin films by sputtering can be increased.

To be more specific, in the case where the oxidation treatment is omitted (the case where the volume resistivity at 25 °C is less than $6.0 \times 10^{11}$ $\Omega \cdot$cm), the Vickers hardness can be 460 or more, and can also be preferably 470 or more, more preferably 480 or more, further preferably 490 or more, still more preferably 500 or more, and particularly preferably 510 or more. In addition, the flexural strength can be 90 MPa or more, and can also be preferably 100 MPa or more, more preferably 110 MPa or more, further preferably 120 MPa or more, and still more preferably 130 MPa or more.

In the case where the oxidation treatment is performed (the case where the volume resistivity at 25 °C is $6.0 \times 10^{11}$ $\Omega \cdot$cm or more), the Vickers hardness can be 210 or more, and can also be preferably 250 or more, more preferably 300 or more, further preferably 350 or more, still more preferably 400 or more, particularly preferably 450 or more, and particularly more preferably 500 or more. In addition, the flexural strength can be 90 MPa or more, and can also be preferably 100 MPa or more, more preferably 110 MPa or more, further preferably 120 MPa or more, and still more preferably 130 MPa or more.

As a result of the above, stability of the Vickers hardness and the relative density before, during, and after the heat treatment can be further improved.

To be more specific, the Vickers hardness after the heat treatment at 900 °C for 5 hours in air can be a magnitude exceeding 50 % of the Vickers hardness before the heat treatment, and can also be preferably a magnitude exceeding 70 % of, more preferably a magnitude exceeding 90 % of, more preferably a magnitude exceeding 95 % of, and more preferably a magnitude exceeding 100 % of the Vickers hardness before the heat treatment.

In addition, the relative density after the heat treatment at 900 °C for 5 hours in air can be a magnitude exceeding 95 % of the relative density before the heat treatment, and can also be preferably a magnitude exceeding 97 % of, more preferably a magnitude exceeding 99 % of, and more preferably a magnitude exceeding 100 % of the relative density before the heat treatment.

The upper limit value of the $A_{<103>}$ is not particularly limited. However, for example, in the case where the relative density of the target material 10 exceeds 95 %, the $A_{<103>}$ is 0.300 or less, preferably 0.250 or less, more preferably 0.200 or less, further preferably 0.150 or less, still more preferably 0.120 or less, particularly preferably 0.110 or less, and particularly more preferably 0.100 or less, thus allowing cracking and chipping of the target material 10 to be more surely suppressed. Accordingly, such values are preferable.

The upper limit value of the $A_{<103>}/A$ is not particularly limited. However, for example, in the case where the relative density of the target material 10 exceeds 95 %, the $A_{<103>}/A$ is 0.60 or less, preferably 0.45 or less, more preferably 0.35 or less, further preferably 0.30 or less, still more preferably 0.25 or less, particularly preferably 0.24 or less, and particularly more preferably 0.20 or less, thus allowing cracking and chipping of the target material 10 to be more surely suppressed. Accordingly, such values are preferable.

The lower limit value of the $A_{<212>+<121>}/A$ is not also particularly limited. However, for example, in the case where the relative density of the target material 10 exceeds 95 %, the $A_{<212>+<121>}/A$ is 0.20 or more, preferably 0.30 or more, more preferably 0.35 or more, further preferably 0.40 or more, still more preferably 0.43 or more, particularly preferably 0.45 or more, and particularly more preferably 0.47 or more, thus allowing cracking and chipping of the target material 10 to be more surely suppressed. Accordingly, such values are preferable.

The lower limit value of the $A_{<101>}/A$ is not also particularly limited. However, for example, in the case where the relative density of the target material 10 exceeds 95 %, the $A_{<101>}/A$ is 0.050 or more, preferably 0.060 or more, more preferably 0.070 or more, further preferably 0.080 or more, and still more preferably 0.100 or more, thus allowing cracking and chipping of the target material 10 to be more surely suppressed. Accordingly, such values are preferable.

The upper limit value of the A is not also particularly limited. However, for example, in the case where the relative density exceeds 95 %, the A is 0.90 or less, preferably 0.75 or less, more preferably 0.60 or less, further preferably 0.55 or less, and still more preferably 0.50 or less, thus allowing cracking and chipping of the target material 10 to be more surely suppressed. Accordingly, such values are preferable.

(d) By suitably selecting production conditions for the target material 10 from the range of the conditions described above, in the case where the oxidation treatment is omitted (the case where the volume resistivity at 25 °C is less than $6.0 \times 10^{11}$ Ω·cm), the carbon concentration can be 200 ppm or less, and can also be preferably 180 ppm or less, more preferably 150 ppm or less, further preferably 130 ppm or less, still more preferably 100 ppm or less, particularly preferably 80 ppm or less, and particularly more preferably 60 ppm or less.

By suitably selecting production conditions for the target material 10 from the range of the conditions described above, in the case where the oxidation treatment is performed (the case where the volume resistivity at 25 °C is $6.0 \times 10^{11}$ Ω·cm or more), the carbon concentration can be 90 ppm or less, and can also be preferably 80 ppm or less, more preferably 50 ppm or less, further preferably 40 ppm or less, still more preferably 30 ppm or less, and particularly preferably 20 ppm or less.

By suitably selecting production conditions for the target material 10 from the range of the conditions described above, in the case where the oxidation treatment is omitted (the case where the volume resistivity at 25 °C is less than $6.0 \times 10^{11}$ Ω·cm), the content of the carbon component in the target material 10 can be $5.0 \times 10^{-9}$ mol/mg or less, and can also be preferably $4.5 \times 10^{-9}$ mol/mg or less, more preferably $4.0 \times 10^{-9}$ mol/mg or less, further preferably $3.5 \times 10^{-9}$ mol/mg or less, still more preferably $3.0 \times 10^{-9}$ mol/mg or less, and particularly preferably $2.5 \times 10^{-9}$ mol/mg or less.

By suitably selecting production conditions for the target material 10 from the range of the conditions described above, in the case where the oxidation treatment is performed (the case where the volume resistivity at 25 °C is $6.0 \times 10^{11}$ Ω·cm or more), the content of the carbon component in the target material 10 can be $4.0 \times 10^{-9}$ mol/mg or less, and can also be preferably $3.0 \times 10^{-9}$ mol/mg or less, more preferably $2.7 \times 10^{-9}$ mol/mg or less, further preferably $2.5 \times 10^{-9}$ mol/mg or less, still more preferably $2.0 \times 10^{-9}$ mol/mg or less, and particularly preferably $1.0 \times 10^{-9}$ mol/mg or less.

In these cases, the mechanical strength of the target material 10 can be further improved.

To be more specific, in the case where the oxidation treatment is omitted (the case where the volume resistivity at 25 °C is less than $6.0 \times 10^{11}$ Ω·cm), the Vickers hardness can be 460 or more, and can also be preferably 470 or more, more preferably 480 or more, further preferably 490 or more, still more preferably 500 or more, and particularly preferably 510 or more. In addition, the flexural strength can be 90 MPa or more, and can also be preferably 100 MPa or more, more preferably 110 MPa or more, further preferably 120 MPa or more, and still more preferably 130 MPa or more.

In the case where the oxidation treatment is performed (the case where the volume resistivity at 25 °C is 6.0 $\times$ 10$^{11}$ $\Omega$·cm or more), the Vickers hardness can be 210 or more, and can also be preferably 250 or more, more preferably 300 or more, further preferably 350 or more, still more preferably 400 or more, particularly preferably 450 or more, and particularly more preferably 500 or more. In addition, the flexural strength can be 90 MPa or more, and can also be preferably 100 MPa or more, more preferably 110 MPa or more, further preferably 120 MPa or more, and further preferably 130 MPa or more.

As a result of the above, stability of the Vickers hardness and the relative density before, during, and after the heat treatment can be further improved.

To be more specific, the Vickers hardness after the heat treatment at 900 °C for 5 hours in air can be a magnitude exceeding 50 % of the Vickers hardness before the heat treatment, and can also be preferably a magnitude exceeding 70 % of, more preferably a magnitude exceeding 90 % of, more preferably a magnitude exceeding 95 % of, and more preferably a magnitude exceeding 100 % of the Vickers hardness before the heat treatment.

In addition, the relative density after the heat treatment at 900 °C for 5 hours in air can be a magnitude exceeding 95 % of the relative density before the heat treatment, and can also be preferably a magnitude exceeding 97 % of, more preferably a magnitude exceeding 99 % of, and more preferably a magnitude exceeding 100 % of the relative density before the heat treatment.

The lower limit value of the carbon concentration is not particularly limited. However, the carbon concentration is 0.1 ppm or more, preferably 0.5 ppm or more, more preferably 1 ppm or more, further preferably 3 ppm or more, and still more preferably 5 ppm or more, thus allowing stress generated by a thermal load during sputtering to be relaxed. Consequently, cracking and chipping of the target material 10 can be more surely suppressed particularly during sputtering. Accordingly, such values are preferable. The lower limit value of the content of the carbon component is not particularly limited. However, the content of the carbon component is 0.01 $\times$ 10$^{-9}$ mol/mg or more, preferably 0.02 $\times$ 10$^{-9}$ mol/mg or more, more preferably 0.05 $\times$ 10$^{-9}$ mol/mg or more, and further preferably 0.1 $\times$ 10$^{-9}$ mol/mg or more, thus allowing stress generated by a thermal load during sputtering to be relaxed. Consequently, cracking and chipping of the target material 10 can be more surely suppressed particularly during sputtering. Accordingly, such values are preferable.

(e) By suitably selecting production conditions for the target material 10 from the range of the conditions described above, in the case where the oxidation treatment is performed (the case where the volume resistivity at 25 °C is 6.0 $\times$ 10$^{11}$ $\Omega$·cm or more), the void ratio can be 12.0 % or less, and can also be preferably 10.0 % or less, more preferably 8.00 % or less, further preferably 6.00 % or less, still more preferably 4.00 % or less, particularly preferably 2.00 % or less, particularly more preferably 1.00 % or less, and particularly further preferably 0.75 % or less. Further, the average diameter of voids can be 0.60 $\mu$m or less, and can also be preferably 0.50 $\mu$m or less, more preferably 0.40 $\mu$m or less, further preferably 0.30 $\mu$m or less, and still more preferably 0.25 $\mu$m or less.

By suitably selecting production conditions for the target material 10 from the range of the conditions described above, in the case where the oxidation treatment is performed (the case where the volume resistivity at 25 °C is 6.0 $\times$ 10$^{11}$ $\Omega$·cm or more), the maximum diameter of a void can be 1.0 $\mu$m or less, and can also be preferably 0.80 $\mu$m or less, more preferably 0.62 $\mu$m or less, further preferably 0.60 $\mu$m or less, still more preferably 0.50 $\mu$m or less, and particularly preferably 0.40 $\mu$m or less.

In these cases, the mechanical strength of the target material 10 can be further improved.

To be more specific, in the case where the oxidation treatment is performed (the case where the volume resistivity at 25 °C is 6.0 $\times$ 10$^{11}$ $\Omega$·cm or more), the Vickers hardness can be 210 or more, and can also be preferably 250 or more, more preferably 300 or more, further preferably 350 or more, still more preferably 400 or more, particularly preferably 450 or more, and particularly more preferably 500 or more. In addition, the flexural strength can be 90 MPa or more, and can also be preferably 100 MPa or more, more preferably 110 MPa or more, further preferably 120 MPa or more, and still more preferably 130 MPa or more.

As a result of the above, stability of the Vickers hardness and the relative density before, during, and after the heat treatment can be further improved.

To be more specific, in the case where the oxidation treatment is performed, the Vickers hardness after the heat treatment at 900 °C for 5 hours in air can be a magnitude exceeding 50 % of the Vickers hardness before the heat treatment, and can also be preferably a magnitude exceeding 70 % of, more preferably a magnitude exceeding 90 % of, more preferably a magnitude exceeding 95 % of, and more preferably a magnitude exceeding 100 % of the Vickers hardness before the heat treatment.

In addition, the relative density after the heat treatment at 900 °C for 5 hours in air can be a magnitude exceeding 95 % of the relative density before the heat treatment, and can also be preferably a magnitude exceeding 97 % of, more preferably a magnitude exceeding 99 % of, and more preferably a magnitude exceeding 100 % of the relative density before the heat treatment.

The lower limit value of the void ratio is not particularly limited. However, in the case where the relative density of the target material 10 exceeds 95 %, the void ratio is 0.05 % or more, preferably 0.10 % or more, more preferably 0.15 % or more, further preferably 0.20 % or more, and still more preferably 0.25 % or more, thus allowing stress generated by a thermal load during sputtering to be relaxed. Consequently, cracking and chipping of the target material 10 can be more surely suppressed particularly during sputtering. Accordingly, such values are preferable.

The lower limit value of the average diameter of voids is not also particularly limited. However, in the case where the relative density of the target material 10 exceeds 95 %, the average diameter of voids is 0.05 $\mu$m or more, preferably 0.10 $\mu$m or more, more preferably 0.15 $\mu$m or more, further preferably 0.20 $\mu$m or more, and still more preferably 0.22 $\mu$m or more, thus allowing stress generated by a thermal load during sputtering to be relaxed. Consequently, cracking and chipping of the target material 10 can be more surely suppressed particularly during sputtering. Accordingly, such values are preferable.

The lower limit value of the maximum diameter of a void is not also particularly limited. However, in the case where the relative density of the target material 10 exceeds 95 %, the maximum diameter of a void is 0.08 $\mu$m or more, preferably 0.12 $\mu$m or more, more preferably 0.18 $\mu$m or more, further preferably 0.20 $\mu$m or more, still more preferably 0.25 $\mu$m or more, particularly preferably 0.30 $\mu$m or more, and particularly more preferably 0.35 $\mu$m or more, thus allowing stress generated by a thermal load during sputtering to be relaxed. Consequently, cracking and chipping of the target material 10 can be more surely suppressed particularly during sputtering. Accordingly, such values are preferable.

<Another aspect of the present disclosure>

Various aspects of the present disclosure have been specifically described heretofore. However, the present disclosure is not limited to the aspects described above, and various modifications are conceivable without departing from the gist of the present disclosure.

[Example]

Although the present disclosure will be more specifically described hereinafter with reference to Examples and Comparative Examples, the present disclosure is not limited to Examples described later. First, devices, conditions, methods, and the like used in measuring target materials prepared in Examples and Comparative Examples will be described.

<Crystal grain size of target material>

Specimen preparation: Performed by a polishing method (a target material was polished with a waterproof polishing paper until large flaws that may hinder evaluation were removed and, thereafter, buff polishing was performed.)

Device: Ultra-high resolution analytical scanning electron microscope SU-70 manufactured by Hitachi High-Tech Corporation
EBSD detector manufactured by TSL SOLUTIONS, K.K.
Analysis software: OIM Analysis Ver8 manufactured by TSL SOLUTIONS, K.K.
Measurement magnification: 3000$\times$
Measurement region: 30 $\mu$m $\times$ 50 $\mu$m
Step size: 0.06 $\mu$m
Grain boundary angle: 15°
Crystallographic information of KNN: A space group and a lattice constant were obtained by an X-ray diffraction method, and information shown in the following table 1 was used.
Analysis method: Clean-up was performed to remove noise, and a grain boundary map was made with a condition of grain boundary angle of 15° (boundaries with a crystal orientation difference of 15° or more were assumed to be crystal grain boundaries) to analyze grain sizes. In the case where voids or the like were present, a threshold was set for an image quality (IQ) value. The area and the grain size (equivalent circle diameter) of each crystal grain were calculated by the Number method and the Area Fraction method using EBSD to obtain a number-average grain size, an area-average grain size, and a standard deviation. In calculating a grain size, microcrystals, and portions that cannot be analyzed due to low crystallinity are removed as noises and hence, crystal grains having a diameter of 0.20 $\mu$m or more were used as the calculation object. The number-average standard deviation Nn ($\mu$m) can be calculated from the distribution of crystal grain sizes of respective crystals (the diameters of equivalent circles for the crystal areas). The grain size of each crystal obtained in calculating the number-average grain size was taken as "$D_i$", and the number-average standard deviation Nn ($\mu$m) was calculated by using the following formula.

$$\text{Number-average standard deviation Nn (}\mu\text{m)} = [\{\Sigma(D_i - Nd)^2\}/\Sigma n_i]^{1/2}$$

<Crystal plane orientation of target material>

Specimen preparation: Performed by a polishing method (a target material was polished with a waterproof polishing paper until large flaws that may hinder evaluation were removed and, thereafter, buff polishing was performed.)
Device: Ultra-high resolution analytical scanning electron microscope SU-70 manufactured by Hitachi High-Tech Corporation
EBSD detector manufactured by TSL SOLUTIONS, K.K.
Analysis software: OIM Analysis Ver8 manufactured by TSL SOLUTIONS, K.K.
Measurement magnification: 3000×
Measurement region: 30 $\mu$m × 50 $\mu$m
Step size: 0.06 $\mu$m
Grain boundary angle: 15°
Misorientation in analysis (allowable angle): 0° to 10°
Crystallographic information of KNN: A space group and a lattice constant were obtained by an X-ray diffraction, and information shown in the following table 1 was used.

Analysis method: Crystal orientation was evaluated by making, by an EBSD method, an inverse pole figure map (with an allowable angle of 0° to 10°) of crystal plane orientation of each specimen. Area ratios of respective crystal orientations were measured from the inverse pole figure of crystal plane orientation of each of the specimens of Examples and Comparative Examples. In measuring the area ratios, respective crystal planes were assumed to have the same orientation when the inclination from the normal direction of each crystal plane is within the range from 0° to 10°. The area ratio of <103> was defined as the total value of the area ratio of <103> and the area ratio of <301>, and the area ratio of <010> was defined as the total value of the area ratio of <010> and the area ratio of <002>.

[Table 1]

| CRYSTAL SYSTEM | LATTICE CONSTANT [Å] | | | ANGLE [°] |
|---|---|---|---|---|
| | a | b | c | $\alpha$, $\beta$, V |
| TETRAGONAL | 7.991 | 7.991 | 7.972 | 90 |

<Void ratio and void diameter of target material>

Specimen preparation: Performed by a polishing method (a target material was polished with a waterproof polishing paper until large flaws that may hinder evaluation were removed and, thereafter, buff polishing was performed.)
Device: Ultra-high resolution field emission scanning electron microscope SU-8000 manufactured by Hitachi High-Tech Corporation
Measurement magnification: 5000×
Analysis method: An SEM image obtained by the above-mentioned device under the above-mentioned conditions was binarized into void portions and a parent phase by using image analysis software "Adobe photoshop (registered trademark)" to calculate the area ratio of the void portions to the measurement area, thus calculating the void ratio. The areas of respective voids were also calculated by using image calculation software "ScnImage" to calculate diameters (equivalent circle diameters) of the respective voids assuming that the shapes of the voids are equivalent circles. The average diameter of voids was obtained by calculating an equivalent circle diameter from the area at which the ratio of the cumulative area to the total of the calculated areas of the respective voids is 50 %. The maximum diameter of a void was extracted from the calculated void diameters.

<Vickers hardness>

Vickers hardness of each of the target materials of Examples and Comparative Examples was measured by using the device described later, under the conditions and with the method described later.

Device: Micro Vickers hardness testing machine HM-114 manufactured by Mitutoyo Corporation
Atmosphere: in air
Temperature: room temperature (25 °C)
Test force: 1.0 kgf
Load application rate: 10 $\mu$m/s
Holding time period: 15 seconds
The number of measurement points: 5 points
Test method: This test conforms to JIS R 1610 where Vickers hardness is obtained from a test force at the time of applying an indentation to a test surface by a Vickers indenter (a quadrangular pyramid indenter where an angle between two facing surfaces is 136 degrees and a bottom surface has a square shape), and from an indentation surface area obtained from the diagonal length of the indentation, and the average was obtained from the measurement results at five points.

<Flexural strength>

Flexural strength of each of the target materials of Examples and Comparative Examples was measured by using the device described later, under the conditions and with the method described later.

Device: Universal testing machine 5582 (load cell 500N) manufactured by Instron
Atmosphere: in air
Temperature: room temperature (25 °C)
Test rate: 0.5 mm/min
Distance between fulcrums: L = 30 mm
Material of jig: SiC
Test method: Evaluated by a three-point bending test in accordance with JIS R 1601. A test piece (size: 3 mm $\times$ 4 mm $\times$ 40 mm) was placed on two fulcrums disposed with a certain distance (30 mm) therebetween, and a bending strength was obtained from the maximum load at which the test piece breaks when a load is applied to the test piece at one point at the center between the fulcrums.

<Relative density>

Relative density of each of the target materials of Examples and Comparative Examples was measured by using the device and method described later.

Device: Electronic densimeter MDS300 manufactured by Alfa Mirage Co., Ltd.
Test method: The density of each target material cut out with a predetermined size was measured, by using the above-mentioned device, by the Archimedes method. The obtained density was divided by the theoretical density (4.52 g/cm$^3$) of KNN to obtain relative density (%) (= measured density/theoretical density $\times$ 100).

<Carbon concentration>

Carbon concentration (the amount of carbon impurities) in each of the target materials of Examples and Comparative Examples was measured by a combustion-infrared absorption method. To be more specific, the cut-out target material sample was rapidly heated by using a high-temperature furnace, CO and $CO_2$ generated from the sample were separated, and a carbon concentration was obtained by infrared measurement.

<Analysis of amount of carbon component>

The amount of the carbon component contained in each of the target materials of Examples and Comparative Examples was obtained by TDS analysis by using the device described later, under the conditions and with the method described later.

Device: TDS1200II manufactured by ESCO, Ltd.
Temperature condition:

Measurement temperature; RT-1200 °C (30 °C/min)
Control thermocouple; T1
Specimen stage; quartz stage/SIC plate/sample/quartz circular lid

Quadrupole mass spectrometer (QMS):

Ionization method; electron ionization
Measurement mode; Bar mode (integer mass number measurement mode)
Measurement range; m/z 1-100 (integration time 50 ms/ch)

Analysis method: A portion of each of the target materials of Examples and Comparative Examples was taken out before and after the oxidation treatment, and was then comminuted with a mortar in air until graininess disappears (a primary particle diameter becomes less than 50 μm), thus preparing approximately 3 mg of comminuted powder. The comminuted powder was heated from room temperature to 1200 °C, and an ionic strength of a component (carbon monoxide) having a mass number (m/z) of 28 and an ionic strength of a component (carbon dioxide) having a mass number of 44 were measured by a mass spectrometer to obtain the component amounts of carbon dioxide and carbon monoxide desorbed at 700 °C to 1000 °C. In the present Example, the number of moles of each desorbed gas per unit mass of the target material (comminuted powder) were obtained assuming that m/z = 28 is carbon monoxide, and m/z = 44 is carbon dioxide.

<Evaluation of insulating property>

The insulating property of each of the target materials of Examples and Comparative Examples was evaluated by measuring their volume resistivity using the device, test, and method described later.

Device: Screen printer MODEL MEC = 2400E manufactured by Mitani Micronics Co., Ltd.

Resistivity measuring device manufactured by NISHIYAMA SEISAKUSHO CO., LTD.
Ultra high resistance meter 5450 manufactured by ADC CORPORATION

Test method: DC three-terminal method
Measurement temperature: room temperature (25 °C)
Measurement atmosphere: argon atmosphere (Ar with purity of 99.9999 % was used, flow rate 300 cc/min)
Measurement method: A target material sample with a predetermined size was cut out, and a main electrode and a guard electrode were provided on the top surface of the target material sample, and a counter electrode was provided on the bottom surface of the target material sample with a screen printer by using a platinum paste manufactured by TANAKA Kikinzoku Kogyo K.K. The respective electrodes can be provided such that platinum paste printed on the sample was dried for 12 hours at 150 °C and, thereafter, was subjected to baking that uses a tubular atmosphere furnace (Ar atmosphere, 1000 °C). The sample provided with the electrodes was held for 15 minutes at room temperature (25 °C) and, thereafter, a DC voltage of 100 V was applied to the sample, and volume resistance of the sample was obtained by measuring an electric current after one minute of charging. Then, volume resistivity was calculated from the thickness and the electrode area of the sample.

<BET specific surface area of KNN raw material powder>

The BET specific surface area of the KNN raw material powder obtained in each Production Example was measured by a BET one-point method of nitrogen adsorption by using a specific surface area measuring device (Monosorb manufactured by Quantachrome Instruments).

[Production of KNN raw material powder 1]

<Production Example 1>

$K_2CO_3$ powder, $Na_2CO_3$ powder, and $Nb_2O_5$ powder were prepared as starting material powders, and the raw material powders were mixed, fired at 650 °C for 7 hours, and were then comminuted by a method described in Japanese Patent Laid Open Publication No. 2018-197181 such that, in terms of atoms, sodium is 32.5 mol%, potassium is 17.5 mol%, niobium is 50.0 mol%, the ratio of alkali metals to niobium ((Na + K)/Nb) is 1.00, and the ratio of potassium to sodium and potassium (K/(Na + K)) is 0.35. With these processes, KNN raw material powder 1 in which K, Na, and Nb are solid-dissolved was obtained. The obtained KNN raw material powder 1 was dissolved in an acid and, thereafter, the composition of the KNN raw material powder 1 was measured by a high-frequency inductively coupled plasma-atomic emission spectrometer. As a result, it was found that the composition of the KNN raw material powder 1 was substantially equal to the feed ratio. It was also found by X-ray diffraction analysis that the KNN raw material powder 1 was solid solutions of K, Na, and Nb. Further, the BET specific surface area of the KNN raw material powder 1 was 6.9 m$^2$/g.

[Production of KNN raw material powder 2]

<Production Example 2>

The KNN raw material powder 1 obtained in Production Example 1 was fired at 750 °C for 5 hours by using an electric furnace, and was then fired at 1000 °C for 5 hours. The fired KNN raw material powder 1 was comminuted by a jet mill (Nano Jetmizer NJ100 manufactured by Aishin Nano Technologies CO., LTD) with conditions of a processing rate of 2 kg/h, an introduction pressure of 1.4 MPa, and a mill pressure of 1.4 MPa, thus obtaining KNN raw material powder 2. The BET specific surface area of the obtained KNN raw material powder 2 was 4.0 m$^2$/g.

[Production of KNN raw material powder 3]

<Production Example 3>

The KNN raw material powder 1 obtained in Production Example 1 was fired at 750 °C for 5 hours by using an electric furnace, and was then fired at 1000 °C for 5 hours, thus obtaining KNN raw material powder 3. The BET specific surface area of the obtained KNN raw material powder 3 was 3.3 m$^2$/g.

[Production of KNN raw material powder 4]

<Production Example 4>

The KNN raw material powder 1 obtained in Production Example 1 was fired at 750 °C for 5 hours by using an electric furnace, and was then fired at 900 °C for 5 hours, thus obtaining KNN raw material powder 4. The BET specific surface area of the obtained KNN raw material powder 4 was 3.6 m$^2$/g.

[Production of KNN raw material powder 5]

<Production Example 5>

$K_2CO_3$ powder, $Na_2CO_3$ powder, and $Nb_2O_5$ powder were prepared as starting material powders, and were mixed such that the value of [K/(K + Na)] is 0.35, and the value of [(Na + K)/Nb] is 1.00, and MnO powder and CuO powder were mixed into the starting material powders such that the starting material powders contain Mn and Cu at predetermined concentrations. Next, the mixture was fired at 650 °C for 7 hours and, thereafter, was comminuted, thus obtaining KNN raw material powder 5 in which K, Na, and Nb are solid-dissolved. The obtained KNN raw material powder 5 was dissolved in an acid and, thereafter, the composition of the KNN raw material powder 5 was measured by a high-frequency inductively coupled plasma-atomic emission spectrometer. As a result, it was found that the composition of the KNN raw material powder 5 was substantially equal to the feed ratio. It was also found by X-ray diffraction analysis that the KNN raw material powder 5 was solid solutions of K, Na, and Nb. Further, the BET specific surface area of the KNN raw material powder 5 was 6.9 m$^2$/g.

[Production of KNN raw material powder 6]

<Production Example 6>

The KNN raw material powder 5 obtained in Production Example 5 was fired at 1000 °C for 5 hours by using an electric furnace. The fired KNN raw material powder 5 was comminuted by a jet mill (Nano Jetmizer NJ100 manufactured by Aishin Nano Technologies CO., LTD) with conditions of a processing rate of 2 kg/h, an introduction pressure of 1.4 MPa, and a mill pressure of 1.4 MPa, thus obtaining KNN raw material powder 6. The BET specific surface area of the obtained KNN raw material powder 6 was 4.4 m$^2$/g.

[Production of KNN raw material powder 7]

<Production Example 7>

150 g of 10 wt% potassium hydroxide aqueous solution and 100 g of $Nb_2O_5$ powder were put into a sealed container made of Teflon (registered trademark), and were subjected to hydrothermal synthesis at 210 °C for 24 hours. After the reaction, the reaction product was subjected to solid-liquid separation, reaction product was collected, and the collected reaction product was washed with water and, thereafter, was dried, thus obtaining $KNbO_3$ powder. Similarly, 150 g of 10 wt% sodium hydroxide aqueous solution and 100 g of $Nb_2O_5$ powder were put into a sealed container made of Teflon (registered trademark), and were subjected to hydrothermal synthesis at 210 °C for 24 hours. After the reaction, the reaction product was subjected to solid-liquid separation, reaction product was collected, and the collected reaction product was washed with water and, thereafter, was dried, thus obtaining $NaNbO_3$ powder. The $KNbO_3$ powder and the $NaNbO_3$ powder obtained by the hydrothermal synthesis were weighed, mixed, and comminuted by a ball mill (using ethanol as a solvent) such that, in terms of atoms, sodium is 32.5 mol%, potassium is 17.5 mol%, niobium is 50.0 mol%, the ratio of alkali metals to niobium ((Na + K)/Nb) is 1.00, and the ratio of potassium to sodium and potassium (K/(Na + K)) is 0.35. With these processes, KNN raw material powder 7 was obtained. In the obtained KNN raw material powder 7, K, Na, and Nb are not solid-dissolved. The obtained KNN raw material powder 7 was dissolved in an acid and, thereafter, the composition of the KNN raw material powder 7 was measured by a high-frequency inductively coupled plasma-atomic emission spectrometer. As a result, it was found that the composition of the KNN raw material powder 7 was substantially equal to the feed ratio. Further, the BET specific surface area of the KNN raw material powder 7 was 10.5 $m^2$/g.

[Example 1]

The KNN raw material powder 2 obtained in Production Example 2 was heated to 200 °C and was dried and, thereafter, was set in a pulse energization pressure sintering apparatus SPS9.40MK-VII (manufactured by SPS SYNTEX INC.) including a die comprising graphite with $\phi$170 mm $\times$ $\phi$101.6 mm $\times$ t100 mm, and a punch comprising graphite with $\phi$101.6 mm $\times$ t65 mm. Heating by discharge plasma was started with the KNN raw material powder 2 being pressurized at 10 MPa in a vacuum atmosphere (with atmospheric pressure being less than 10 Pa) to raise the temperature from 25 °C to 900 °C at a rate of 50 °C/min. During this period, desorption of gas components and a rise in atmospheric pressure were found. After the pressure was gradually raised to 35 MPa, the temperature was raised to 950 °C at 2.5 °C/min, and was held at 950 °C for 30 minutes. Thereafter, energization and pressurizing were stopped, and cooling was performed, thus obtaining a target material (KNN sintered ceramics, a target material with low insulating property) having a disk shape with a diameter of approximately 101 mm and a thickness of 5 mm.

After the obtained target material was subjected to oxidation treatment at 900 °C for 5 hours in air, the target material was finished by grinding the surface of the obtained target material, thus obtaining a KNN target material (a target material with high insulating property) having a diameter of 100 mm and a thickness of 5 mm.

After the obtained target material was subjected to microwave decomposition, the composition of the target material was measured by a high-frequency inductively coupled plasma-atomic emission spectrometer. As a result, it was found that the value of [K/(K + Na)] was 0.35, and the value of [(Na + K)/Nb] was 1.0.

<Conditions of low pressure SPS>

Mechanical pressure: 10 MPa
Heating temperature: to 900 °C
Atmospheric pressure (the pressure in the chamber): less than 10 Pa (when raising pressure, 30 Pa)

<Conditions of main SPS>

Mechanical pressure: 35 MPa (pressurization was started at 900 °C)
Heating temperature: 950 °C
Atmospheric pressure (the pressure in the chamber): less than 10 Pa

[Example 2]

A KNN target material having a diameter of 100 mm and a thickness of 5 mm was obtained by a method similar to that used in Example 1 except that the KNN raw material powder 3 obtained in Production Example 3 was used and the main SPS was performed under conditions described later.

<Conditions of main SPS>

Mechanical pressure: 30 MPa (pressurization was started at 900 °C)
Heating temperature: 1020 °C (the temperature was raised from 900 °C at 10 °C/min and, after reaching 1020 °C, was held for 75 minutes)
Atmospheric pressure (the pressure in the chamber): less than 10 Pa

[Example 3]

A KNN target material having a diameter of 100 mm and a thickness of 5 mm was obtained by a method similar to that used in Example 1 except that the KNN raw material powder 4 obtained in Production Example 4 was used and the main SPS was performed under conditions described later.

<Conditions of main SPS>

Mechanical pressure: 40 MPa (pressurization was started at 900 °C)
Heating temperature: 900 °C to 1010 °C (the temperature was raised from 900 °C to 1010 °C at 2.5 °C/min, no holding time period)
Atmospheric pressure (the pressure in the chamber): less than 10 Pa

[Example 4]

A KNN target material having a diameter of 100 mm and a thickness of 5 mm was obtained by a method similar to that used in Example 1 except that the KNN raw material powder 6 obtained in Production Example 6 was used and the low pressure SPS and the main SPS were performed under conditions described later.

<Conditions of low pressure SPS>

Mechanical pressure: 5 MPa
Heating temperature (degassing temperature): to 800 °C (the temperature was raised from 25 °C to 800 °C at 3 °C/min)
Atmospheric pressure (the pressure in the chamber): less than 10 Pa (when raising pressure, 30 Pa)

<Conditions of main SPS>

Mechanical pressure: 40 MPa (pressurization was started at 800 °C)
Heating temperature: 900 °C (the temperature was raised from 800 °C to 900 °C at 3 °C/min and, thereafter, was held for 3 hours)
Atmospheric pressure (the pressure in the chamber): less than 10 Pa

[Example 5]

A KNN target material having a diameter of 100 mm and a thickness of 5 mm was obtained by a method similar to that used in Example 1 except that the KNN raw material powder 7 obtained in Production Example 7 was used.

[Comparison Example 1]

A KNN target material having a diameter of 100 mm and a thickness of 5 mm was obtained by a method similar to that used in Example 1 except that the KNN raw material powder 1 obtained in Production Example 1 was used and the low pressure SPS and the main SPS were performed under conditions described later.

<Conditions of low pressure SPS>

Mechanical pressure: 10 MPa
Heating temperature: 400 °C (the temperature was raised from 25 °C to 400 °C at 40 °C/min and, thereafter, was held for 50 minutes)
Atmospheric pressure (the pressure in the chamber): less than 10 Pa (when raising pressure, 20 Pa)

<Conditions of main SPS>

Mechanical pressure: 40 MPa (pressurization was started at 400 °C)
Heating temperature: to 915 °C (the temperature was raised from 400 °C to 600 °C at 10 °C/min and, thereafter, was held for 20 minutes, and was then raised to 700 °C at 5 °C/min and, thereafter, was held for 30 minutes. Thereafter, the temperature was raised to 915 °C at 1.3 °C/min, and was held for 45 minutes)
Atmospheric pressure (the pressure in the chamber): less than 10 Pa

[Comparison Example 2]

A KNN target material having a diameter of 100 mm and a thickness of 5 mm was obtained by a method similar to that used in Example 1 except that the KNN raw material powder 5 obtained in Production Example 5 was used and the low pressure SPS and the main SPS were performed under conditions described later.

<Conditions of low pressure SPS>

Mechanical pressure: 10 MPa
Heating temperature: 400 °C (the temperature was raised from 25 °C to 400 °C at 13 °C/min and, thereafter, was held for 60 minutes)
Atmospheric pressure (the pressure in the chamber): less than 10 Pa (when raising pressure, 20 Pa)

<Conditions of main SPS>

Mechanical pressure: 40 MPa (pressurization was started at 400 °C)
Heating temperature: to 910 °C (the temperature was raised from 400 °C to 800 °C at 4 °C/min. Thereafter, the temperature was raised to 910 °C at 1.2 °C/min and, thereafter, was held for 10 minutes)
Atmospheric pressure (the pressure in the chamber): less than 10 Pa

[Comparison Example 3]

A KNN target material having a diameter of 100 mm and a thickness of 5 mm was obtained by a method similar to that used in Example 1 except that the KNN raw material powder 1 obtained in Production Example 1 was used, the low pressure SPS was not performed, and the main SPS was performed under conditions described later.

<Condition of low pressure SPS>

Not performed

<Conditions of main SPS>

Mechanical pressure: 40 MPa (pressurization was started at 25 °C)

Heating temperature: 800 °C (the temperature was raised from 25 °C to 800 °C at 50 °C/min and, thereafter, was held for 160 minutes)
Atmospheric pressure (the pressure in the chamber): less than 10 Pa (when raising pressure, 30 Pa)

<Evaluation of crystal grain size>

The sputter surface of each of the target materials prepared in Examples 1 to 4 and Comparative Example 1 was observed by EBSD to calculate the number-average grain size Nd ($\mu$m), the area-average grain size Nv ($\mu$m), the number-average standard deviation Nn ($\mu$m), the area-average standard deviation Ns ($\mu$m), (Nv - Nd)/Nd, and Ns/Nv of a plurality of crystal grains observed on the sputter surface.

Vickers hardness, relative density, and flexural strength of each of the target materials of Examples 1 to 4 and Comparative Example 1 were also measured.

Each of Vickers hardness and relative density of the target material was measured at two timings, that is, before oxidation treatment (in a state where the volume resistivity at 25 °C was less than $6.0 \times 10^{11}$ $\Omega \cdot$cm), and after the oxidation treatment (in a state where the volume resistivity at 25 °C was $6.0 \times 10^{11}$ $\Omega \cdot$cm or more). In each of the target materials obtained in Examples and Comparative Example, the volume resistivity at 25 °C before the oxidation treatment was less than $6.0 \times 10^{11}$ $\Omega \cdot$cm, and the volume resistivity at 25 °C after the oxidation treatment was $6.0 \times 10^{11}$ $\Omega \cdot$cm or more. Flexural strength was measured at a timing after the oxidation treatment. Flexural strength is not changed due to the oxidation treatment, or is slightly decreased due to loss of carbon as impurities from a sintered ceramics and hence, flexural strength before the oxidation treatment is equal to or higher than flexural strength after the oxidation treatment.

These measurement results are shown in table 2.

[Table 2]

| | NUMBER-AVERAGE GRAIN SIZE Nd [$\mu$m] | NUMBER-AVERAGE STANDARD DEVIATION Nn [$\mu$m] | AREA-AVERAGE GRAIN SIZE Nv [$\mu$m] | AREA-AVERAGE STANDARD DEVIATION Ns [$\mu$m] | (Nv-Nd) INd | Ns/Nv | FLEXURAL STRENGTH [MPa] | VICKERS HARDNESS | | RELATIVE DENSITY [%] | |
|---|---|---|---|---|---|---|---|---|---|---|---|
| | | | | | | | | BEFORE OXIDATION TREATMENT | AFTER OXIDATION TREATMENT | BEFORE OXIDATION TREATMENT | AFTER OXIDATION TREATMENT |
| EXAMPLE 1 | 0.34 | 0.14 | 0.48 | 0.22 | 0.41 | 0.46 | 199 | 510 | 527 | 98.7 | 98.5 |
| EXAMPLE 2 | 0.60 | 0.36 | 1.05 | 0.50 | 0.75 | 0.48 | 115 | 470 | 471 | 99.6 | 99.6 |
| EXAMPLE 3 | 0.49 | 0.23 | 0.71 | 0.29 | 0.45 | 0.41 | 137 | 510 | 508 | 99.3 | 99.3 |
| EXAMPLE 4 | 0.71 | 0.38 | 1.21 | 0.67 | 0.70 | 0.55 | 166 | 464 | 447 | 98.4 | 97.3 |
| COM.EX. 1 | 0.55 | 0.47 | 1.74 | 1.35 | 2.16 | 0.78 | 60 | 450 | 210 | 97.3 | 88.9 |
| *COM.EX. = COMPARATIVE EXAMPLE | | | | | | | | | | | |

28

It was found that, in each of the target materials of Examples 1 to 4, the area-average grain size Nv ($\mu$m) and the area-average standard deviation Ns ($\mu$m) were relatively small, (Nv - Nd)/Nd was 2.1 or less, and Ns/Nv was 0.76 or less.

It was found that, in each of the target materials of Examples 1 to 4, the Vickers hardness before the oxidation treatment was 460 or more, and the Vickers hardness after the oxidation treatment was 250 or more. It was also found that, in each of the target materials of Examples 1 to 4, the flexural strength after the oxidation treatment was 90 MPa or more. Consequently, it can be presumed that, in each of the target materials of Examples 1 to 4, the flexural strength before the oxidation treatment was also 90 MPa or more. It was found that the target materials of Examples 1 to 4 had these mechanical strength properties, thus exhibiting cracking or chipping neither during grinding nor during a sputtering deposition process performed after the grinding.

When a comparison was made between the Vickers hardness before the oxidation treatment and the Vickers hardness after the oxidation treatment for each of the target materials of Examples 1 to 4, it was found that there was no significant change between these values, and the Vickers hardness after the heat treatment (oxidation treatment) was maintained at a magnitude exceeding 50 % of the Vickers hardness before the heat treatment.

When a comparison was made between the relative density before the oxidation treatment and the relative density after the oxidation treatment for each of the target materials of Examples 1 to 4, it was found that there was also no significant change between these values, and the relative density after the heat treatment (oxidation treatment) was maintained at a magnitude exceeding 95 % of the relative density before the heat treatment.

In contrast, it was found that, in the target material of Comparative Example 1, the area-average grain size Nv ($\mu$m) and the area-average standard deviation Ns ($\mu$m) were relatively large, (Nv - Nd)/Nd was over 2.1, and Ns/Nv was over 0.76.

It was found that, in the target material of Comparative Example 1, the Vickers hardness before the oxidation treatment was less than 460, and the Vickers hardness after the oxidation treatment was less than 250. It was also found that, in the target material of Comparative Example 1, the flexural strength after the oxidation treatment was less than 90 MPa. Consequently, it can be inferred that, in the target material of Comparative Example 1, the flexural strength before the oxidation treatment was also less than 90 MPa. It was found that, in the target material of Comparative Example 1, cracking or chipping occurs during grinding as well as during the sputtering deposition process performed after the grinding. In the sputtering deposition process, a sputtering target was used in which the target material is joined to an oxygen-free copper backing plate by In soldering.

When a comparison was made between the Vickers hardness before the oxidation treatment and the Vickers hardness after the oxidation treatment for the target material of Comparative Example 1, it was found that there was a significant change between these values, and the Vickers hardness after the heat treatment (oxidation treatment) was reduced to a magnitude of 50 % or less of the Vickers hardness before the heat treatment.

When a comparison was made between the relative density before the oxidation treatment and the relative density after the oxidation treatment for the target material of Comparative Example 1, it was found that there was also a relatively significant change between these values, and the relative density after the heat treatment (oxidation treatment) was reduced to a magnitude of 95 % or less of the relative density before the heat treatment.

In each of Examples 1 to 4, the number-average standard deviation Nn was less than 0.47 $\mu$m, the area-average standard deviation Ns was less than 1.35 $\mu$m, and Nn/Nd was less than 0.85 (0.41 in Example 1, 0.60 in Example 2, 0.47 in Example 3, 0.54 in Example 4, and 0.85 in Comparative Example 1). It was found that these values of Examples 1 to 4 were smaller than those of Comparative Example 1, so that each of Examples 1 to 4 had a small variation in crystal grain size.

<Evaluation of crystal orientation>

The sputter surface of each of the target materials prepared in Examples 1 to 4 and Comparative Example 2 was observed by EBSD to measure crystal plane orientations of a plurality of crystal grains observed in the observation region. Assuming the area of the observation region to be 1, the area ratio $A_{<101>}$ of a crystal plane with $<101>_{0-10°}$ orientation, the area ratio $A_{<10>}$ of a crystal plane with $<010>_{0-10°}$ orientation, the area ratio $A_{<111>}$ of a crystal plane with $<111>_{0-10°}$ orientation, the area ratio $A_{<103>}$ of a crystal plane with $<103>_{0-10°}$ orientation, the area ratio $A_{<212>}$ of a crystal plane with $<212_{0-10°}$ orientation, the area ratio $A_{<121>}$ of a crystal plane with $<121>_{0-10°}$ orientation, and the total area ratio A of these fractions were measured. The $A<_{103}>/A$, the $A_{<212>} + <_{121>}/A$, the $A_{<101>}/A$, and the A were calculated based on these measurement results.

Vickers hardness, relative density, and flexural strength of each of the target materials prepared in Examples 1 to 4 and Comparative Example 2 were measured.

Each of Vickers hardness and relative density of the target material was measured at two timings, that is, before the oxidation treatment (in a state where the volume resistivity at 25 °C was less than $6.0 \times 10^{11}$ $\Omega \cdot$cm), and after the oxidation treatment (in a state where the volume resistivity at 25 °C was $6.0 \times 10^{11}$ $\Omega \cdot$cm or more). In each of the target materials obtained in Examples and Comparative Example, the volume resistivity at 25 °C before the oxidation treatment was less than $6.0 \times 10^{11}$ Ω·cm, and the volume resistivity at 25 °C after the oxidation treatment was $6.0 \times 10^{11}$ Ω·cm or more. Flexural strength was measured at a timing after the oxidation treatment. Flexural strength is not changed due to the oxidation treatment, or is slightly decreased due to loss of carbon as impurities from a sintered ceramics and hence, flexural strength before the oxidation treatment is equal to or higher than flexural strength after the oxidation treatment.

These measurement results are shown in table 3. Note that <101>, <010>, <111>, <103>, <212>, and <121> shown in table 3 indicate the area ratio $A_{<101>}$, the area ratio $A_{<010>}$, the area ratio $A_{<111>}$, the area ratio $A_{<103>}$, the area ratio $A_{<212>}$, and the area ratio $A_{<121>}$ per unit area of the sputter surface. Accordingly, it can be regarded that the value of the total area ratio A obtained by summing these values corresponds to the total area ratio A per unit area of the sputter surface.

[Table 3]

| | CRYSTAL ORIENTATION RATIO (0° to 10°) | | | | | | | | | | FLEXURAL STRENGTH [MPa] | VICKERS HARDNESS | | RELATIVE DENSITY [%] | |
| | $\langle 101\rangle$ | $\langle 010\rangle$ | $\langle 111\rangle$ | $\langle 103\rangle$ | $\langle 212\rangle$ | $\langle 121\rangle$ | TOTAL AREA RATIO A | $\langle 103\rangle$/A | $(\langle 212\rangle+\langle 121\rangle)$/A | $\langle 101\rangle$/A | | BEFORE OXIDATION TREATMENT | AFTER OXIDATION TREATMENT | BEFORE OXIDATION TREATMENT | AFTER OXIDATION TREATMENT |
|---|---|---|---|---|---|---|---|---|---|---|---|---|---|---|---|
| EXAMPLE 1 | 0.045 | 0.042 | 0.060 | 0.088 | 0.106 | 0.128 | 0.469 | 0.188 | 0.500 | 0.101 | 199 | 510 | 527 | 98.7 | 98.5 |
| EXAMPLE 2 | 0.065 | 0.050 | 0.052 | 0.124 | 0.099 | 0.111 | 0.501 | 0.248 | 0.419 | 0.130 | 115 | 470 | 471 | 99.6 | 99.6 |
| EXAMPLE 3 | 0.041 | 0.042 | 0.060 | 0.119 | 0.096 | 0.117 | 0.475 | 0.251 | 0.448 | 0.086 | 137 | 510 | 508 | 99.3 | 99.3 |
| EXAMPLE 4 | 0.03 | 0.074 | 0.055 | 0.094 | 0.085 | 0.147 | 0.485 | 0.194 | 0.478 | 0.062 | 166 | 464 | 447 | 98.4 | 97.3 |
| COM.EX. 2 | 0.012 | 0.048 | 0.034 | 0.060 | 0.039 | 0.178 | 0.371 | 0.162 | 0.585 | 0.032 | 70 | 440 | 190 | 97.3 | 90.0 |

*COM.EX. = COMPARATIVE EXAMPLE

It was found that, in each of the target materials of Examples 1 to 4, the $A_{\langle 103\rangle}$ was 0.061 or more, the $A_{\langle 103\rangle}$/A was 0.165 or more, the $A_{\langle 212\rangle+\langle 121\rangle}$/A was 0.580 or less, and A was 0.40 or more. It was also found that, in each of the target materials of Examples 1 to 4, except the target material of Example 2, the $A_{<101>}/A$ was less than 0.13.

It was found that, in each of the target materials of Examples 1 to 4, the Vickers hardness before the oxidation treatment was 460 or more, and the Vickers hardness after the oxidation treatment was 250 or more. It was also found that, in each of the target materials of Examples 1 to 4, the flexural strength after the oxidation treatment was 90 MPa or more. Consequently, it can be presumed that, in each of the target materials of Examples 1 to 4, the flexural strength before the oxidation treatment was also 90 MPa or more. It was found that the target materials of Examples 1 to 4 had these mechanical strength properties, thus exhibiting cracking or chipping neither during grinding nor during the sputtering deposition process performed after the grinding.

When a comparison was made between the Vickers hardness before the oxidation treatment and the Vickers hardness after the oxidation treatment for each of the target materials of Examples 1 to 4, it was found that there was no significant change between these values, and the Vickers hardness after the heat treatment (oxidation treatment) was maintained at a magnitude exceeding 50 % of the Vickers hardness before the heat treatment.

When a comparison was made between the relative density before the oxidation treatment and the relative density after the oxidation treatment for each of the target materials of Examples 1 to 4, it was found that there was also no significant change between these values, and the relative density after the heat treatment (oxidation treatment) was maintained at a magnitude exceeding 95 % of the relative density before the heat treatment.

In contrast, it was found that, in the target material of Comparative Example 2, the $A_{<103>}$ was less than 0.061, the $A_{<103>}/A$ was less than 0.165, the $A_{<212>+<121>}/A$ was over 0.580, and A was less than 0.40.

It was found that, in the target material of Comparative Example 2, the Vickers hardness before the oxidation treatment was less than 460, and the Vickers hardness after the oxidation treatment was less than 250. It was also found that, in the target material of Comparative Example 2, the flexural strength after the oxidation treatment was less than 90 MPa. Consequently, it can be inferred that, in the target material of Comparative Example 2, the flexural strength before the oxidation treatment was also less than 90 MPa. It was found that the target material of Comparative Example 2 exhibited cracking or chipping during grinding as well as during the sputtering deposition process performed after the grinding.

When a comparison was made between the Vickers hardness before the oxidation treatment and the Vickers hardness after the oxidation treatment for the target material of Comparative Example 2, it was found that there was a significant change between these values, and the Vickers hardness after the heat treatment (oxidation treatment) was reduced to a magnitude of 50 % or less of the Vickers hardness before the heat treatment.

When a comparison was made between the relative density before the oxidation treatment and the relative density after the oxidation treatment for the target material of Comparative Example 2, it was found that there was also a relatively significant change between these values, and the relative density after the heat treatment (oxidation treatment) was reduced to a magnitude of 95 % or less of the relative density before the heat treatment.

<Evaluation of carbon concentration>

The carbon concentration in each of the target materials prepared in Examples 1, 3 to 5 and Comparative Example 1 was measured by a combustion-infrared absorption method (Instrumental Gas Analysis) at two timings, that is, before the oxidation treatment (in a state where the volume resistivity at 25 °C was less than $6.0 \times 10^{11}$ $\Omega \cdot cm$), and after the oxidation treatment (in a state where the volume resistivity at 25 °C was $6.0 \times 10^{11}$ $\Omega \cdot cm$ or more).

Vickers hardness, relative density, and flexural strength of each of the target materials prepared in Examples 1, 3 to 5 and Comparative Example 1 were measured.

Each of Vickers hardness and relative density of the target material was measured at two timings, that is, before the oxidation treatment (in a state where the volume resistivity at 25 °C was less than $6.0 \times 10^{11}$ $\Omega \cdot cm$), and after the oxidation treatment (in a state where the volume resistivity at 25 °C was $6.0 \times 10^{11}$ $\Omega \cdot cm$ or more). In each of the target materials obtained in Examples and Comparative Example, the volume resistivity at 25 °C before the oxidation treatment was less than $6.0 \times 10^{11}$ $\Omega \cdot cm$, and the volume resistivity at 25 °C after the oxidation treatment was $6.0 \times 10^{11}$ $\Omega \cdot cm$ or more. Flexural strength was measured at a timing after the oxidation treatment. Flexural strength is not changed due to the oxidation treatment, or is slightly decreased due to loss of carbon as impurities from a sintered ceramics and hence, flexural strength before the oxidation treatment is equal to or higher than flexural strength after the oxidation treatment.

These measurement results are shown in table 4.

[Table 4]

| | CARBON CONCENTRATION [wt ppm] | | FLEXURAL STRENGTH [MPa] | VICKERS HARDNESS | | RELATIVE DENSITY [%] | |
| | BEFORE OXIDATION TREATMENT | AFTER OXIDATION TREATMENT | | BEFORE OXIDATION TREATMENT | AFTER OXIDATION TREATMENT | BEFORE OXIDATION TREATMENT | AFTER OXIDATION TREATMENT |
|---|---|---|---|---|---|---|---|
| EXAMPLE 1 | 50 | <10 | 199 | 510 | 527 | 98.7 | 98.5 |
| EXAMPLE 3 | 63 | 13 | 137 | 510 | 508 | 99.3 | 99.3 |
| EXAMPLE 4 | 120 | 12 | 166 | 464 | 447 | 98.4 | 97.3 |
| EXAMPLE 5 | 20 | <5 | 205 | 540 | 543 | 99.5 | 99.5 |
| COM.EX. 1 | 260 | 95 | 60 | 450 | 210 | 97.3 | 88.9 |
| *COM.EX. = COMPARATIVE EXAMPLE | | | | | | | |

It was found that, in each of the target materials of Examples 1, and 3 to 5, the carbon concentration was relatively low, the carbon concentration before the oxidation treatment was 200 ppm or less, and the carbon concentration after the oxidation treatment was 90 ppm or less.

It was found that, in each of the target materials of Examples 1, and 3 to 5, the Vickers hardness before the oxidation treatment was 460 or more, and the Vickers hardness after the oxidation treatment was 250 or more. It was also found that, in each of the target materials of Examples 1 and 4, the flexural strength after the oxidation treatment was 90 MPa or more. Consequently, it can be presumed that, in each of the target materials of Examples 1, and 3 to 5, the flexural strength before the oxidation treatment was also 90 MPa or more. It was found that the target materials of Examples 1, and 3 to 5 had these mechanical strength properties, thus exhibiting cracking or chipping neither during grinding nor during the sputtering deposition process performed after the grinding.

When a comparison was made between the Vickers hardness before the oxidation treatment and the Vickers hardness after the oxidation treatment for each of the target materials of Examples 1, and 3 to 5, it was found that there was no significant change between these values, and the Vickers hardness after the heat treatment (oxidation treatment) was maintained at a magnitude exceeding 50 % of the Vickers hardness before the heat treatment.

When a comparison was made between the relative density before the oxidation treatment and the relative density after the oxidation treatment for each of the target materials of Examples 1, and 3 to 5, it was found that there was also no significant change between these values, and the relative density after the heat treatment (oxidation treatment) was maintained at a magnitude exceeding 95 % of the relative density before the heat treatment.

It was also found that the amount of the carbon component contained in the target material of Example 1 before the oxidation treatment was $0.5 \times 10^{-9}$ mol/mg as converted to carbon dioxide, and was $1.4 \times 10^{-9}$ mol/mg as converted to carbon monoxide, and the total amount was $1.9 \times 10^{-9}$ mol/mg. It was found that the amount of the carbon component contained in the target material of Example 4 before the oxidation treatment was $1.6 \times 10^{-9}$ mol/mg as converted to carbon dioxide, and was $2.3 \times 10^{-9}$ mol/mg as converted to carbon monoxide, the total amount was $3.9 \times 10^{-9}$ mol/mg, and the total amount of the carbon component as converted to carbon dioxide and the carbon component as converted to carbon monoxide was $5.0 \times 10^{-9}$ mol/mg or less.

It was also found that the amount of the carbon component contained in the target material of Example 4 after the oxidation treatment was $1.2 \times 10^{-9}$ mol/mg as converted to carbon dioxide, and was $1.8 \times 10^{-9}$ mol/mg as converted to carbon monoxide, the total amount was $3.0 \times 10^{-9}$ mol/mg, and the total amount of the carbon component as converted to carbon dioxide and the carbon component as converted to carbon monoxide was $4.0 \times 10^{-9}$ mol/mg or less.

In contrast, it was found that, in the target material of Comparative Example 1, the carbon concentration was high, the carbon concentration before the oxidation treatment was over 200 ppm, and the carbon concentration after the oxidation treatment was over 90 ppm.

It was found that, in the target material of Comparative Example 1, the Vickers hardness before the oxidation treatment was less than 460, and the Vickers hardness after the oxidation treatment was less than 250. It was also found that, in the target material of Comparative Example 1, the flexural strength after the oxidation treatment was less than 90 MPa. Consequently, it can be inferred that, in the target material of Comparative Example 1, the flexural strength before the oxidation treatment was also less than 90 MPa. It was found that the target material of Comparative Example 1 exhibited cracking or chipping during grinding as well as during the sputtering deposition process performed after the grinding.

When a comparison was made between the Vickers hardness before the oxidation treatment and the Vickers hardness after the oxidation treatment for the target material of Comparative Example 1, it was found that there was a significant change between these values, and the Vickers hardness after the heat treatment (oxidation treatment) was reduced to a magnitude of 50 % or less of the Vickers hardness before the heat treatment.

When a comparison was made between the relative density before the oxidation treatment and the relative density after the oxidation treatment for the target material of Comparative Example 1, it was found that there was also a relatively significant change between these values, and the relative density after the heat treatment (oxidation treatment) was reduced to a magnitude of 95 % or less of the relative density before the heat treatment.

<Evaluation of void>

The sputter surface of each of the target materials prepared in Examples 2, 3, and Comparative Examples 2, 3 was observed by SEM to measure a void ratio (%), being the ratio of the total area of voids present on the sputter surface, the average diameter ($\mu$m) of voids present on the sputter surface, and the maximum diameter ($\mu$m).

Vickers hardness, relative density, and flexural strength of each of the target materials prepared in Examples 2, 3, and Comparative Examples 2, 3 were measured.

Each of Vickers hardness and relative density was measured at two timings, that is, before the oxidation treatment (in a state where the volume resistivity at 25 °C was less than $6.0 \times 10^{11}$ $\Omega \cdot$cm), and after the oxidation treatment (in a state where the volume resistivity at 25 °C was $6.0 \times 10^{11}$ $\Omega \cdot$cm or more). In each of the target materials obtained in Examples and Comparative Examples, the volume resistivity at 25 °C before the oxidation treatment was less than $6.0 \times 10^{11}$ $\Omega \cdot$cm, and the volume resistivity at 25 °C after the oxidation treatment was $6.0 \times 10^{11}$ $\Omega \cdot$cm or more. Flexural strength was measured at a timing after the oxidation treatment. Flexural strength is not changed due to the oxidation treatment, or is slightly decreased due to loss of carbon as impurities from a sintered ceramics and hence, flexural strength before the oxidation treatment is equal to or higher than flexural strength after the oxidation treatment.

These measurement results are shown in table 5.

[Table 5]

| | AVERAGE DIAMETER OF VOIDS [μm] | MAXIMUM DIAMETER OF VOID [μm] | VOID RATIO [%] | FLEXURAL STRENGTH [MPa] | VICKERS HARDNESS | | RELATIVE DENSITY [%] | |
|---|---|---|---|---|---|---|---|---|
| | | | | | BEFORE OXIDATION TREATMENT | AFTER OXIDATION TREATMENT | BEFORE OXIDATION TREATMENT | AFTER OXIDATION TREATMENT |
| EXAMPLE 2 | 0.21 | 0.29 | 0.24 | 115 | 470 | 471 | 99.6 | 99.6 |
| EXAMPLE 3 | 0.25 | 0.54 | 0.58 | 137 | 510 | 508 | 99.3 | 99.3 |
| COM.EX.2 | 0.61 | 1.11 | 11.19 | 70 | 440 | 190 | 97.3 | 90.0 |
| COM.EX. 3 | 0.26 | 0.64 | 13.25 | 84 | 450 | 220 | 98.2 | 93.0 |
| *COM.EX. = COMPARATIVE EXAMPLE | | | | | | | | |

It was found that, in each of the target materials of Examples 2 and 3, the void ratio was 12.0 % or less, the average diameter of voids was 0.60 µm or less, and the maximum diameter of a void was 1.0 µm or less.

It was found that, in each of the target materials of Examples 2 and 3, the Vickers hardness before the oxidation treatment was 460 or more, and the Vickers hardness after the oxidation treatment was 250 or more. It was also found that, in each of the target materials of Examples 2 and 3, the flexural strength after the oxidation treatment was 90 MPa or more. Consequently, it can be presumed that, in each of the target materials of Examples 2 and 3, the flexural strength before the oxidation treatment was also 90 MPa or more. It was found that the target materials of Examples 2 and 3 had these mechanical strength properties, thus exhibiting cracking or chipping neither during grinding nor during the sputtering deposition process performed after the grinding.

When a comparison was made between the Vickers hardness before the oxidation treatment and the Vickers hardness after the oxidation treatment for each of the target materials of Examples 2 and 3, it was found that there was no significant change between these values, and the Vickers hardness after the heat treatment (oxidation treatment) was maintained at a magnitude exceeding 50 % of the Vickers hardness before the heat treatment.

When a comparison was made between the relative density before the oxidation treatment and the relative density after the oxidation treatment for each of the target materials of Examples 2 and 3, it was found that there was also no significant change between these values, and the relative density after the heat treatment (oxidation treatment) was maintained at a magnitude exceeding 95 % of the relative density before the heat treatment.

In contrast, it was found that, in each of the target materials of Comparative Examples 2 and 3, the void ratio was over 12.0 %, or the average diameter of voids was over 0.6 µm, and the maximum diameter of a void was larger than those of Examples 2 and 3.

It was found that, in each of the target materials of Comparative Examples 2 and 3, the Vickers hardness before the oxidation treatment was less than 460, and the Vickers hardness after the oxidation treatment was less than 250. It was also found that, in each of the target materials of Comparative Examples 2 and 3, the flexural strength after the oxidation treatment was less than 90 MPa. Consequently, it can be inferred that, in each of the target materials of Comparative Examples 2 and 3, the flexural strength before the oxidation treatment was also less than 90 MPa. It was found that the target materials of Comparative Examples 2 and 3 exhibited cracking or chipping during grinding as well as during the sputtering deposition process performed after the grinding.

When a comparison was made between the Vickers hardness before the oxidation treatment and the Vickers hardness after the oxidation treatment for each of the target materials of Comparative Examples 2 and 3, it was found that there was a significant change between these values, and the Vickers hardness after the heat treatment (oxidation treatment) was reduced to a magnitude of 50 % or less of the Vickers hardness before the heat treatment.

When a comparison was made between the relative density before the oxidation treatment and the relative density after the oxidation treatment for each of the target materials of Comparative Examples 2 and 3, it was found that there was also a relatively significant change between these values, and the relative density after the heat treatment (oxidation treatment) was reduced to a magnitude of 95 % or less of the relative density before the heat treatment.

<Preferred Aspects of Present Disclosure>

Hereinafter, preferred aspects of the present disclosure will be described.

(Supplementary description 1)

According to an aspect of the present disclosure, there is provided a sputtering target material comprising a sintered ceramics of an oxide containing potassium, sodium, niobium, and oxygen, wherein
when a volume resistivity at 25 °C is less than $6.0 \times 10^{11}$ Ω·cm, a Vickers hardness is 460 or more, and a flexural strength is 90 MPa or more.

(Supplementary description 2)

According to another aspect of the present disclosure, there is provided a sputtering target material comprising a sintered ceramics of an oxide containing potassium, sodium, niobium, and oxygen, wherein
when a volume resistivity at 25 °C is $6.0 \times 10^{11}$ Ω·cm or more, a Vickers hardness is 250 or more, and a flexural strength is 90 MPa or more.

(Supplementary description 3)

Preferably, there is provided the sputtering target material, wherein a Vickers hardness after heat treatment at 900 °C for 5 hours in air is maintained at a magnitude exceeding 50 % of a Vickers hardness before the heat treatment.

(Supplementary description 4)

Preferably, there is provided the sputtering target material, wherein a relative density after heat treatment at 900 °C for 5 hours in air is maintained at a magnitude exceeding 95 % of a relative density before the heat treatment.

(Supplementary description 5)

According to further another aspect of the present disclosure, there is provided a sputtering target material comprising a sintered ceramics of an oxide containing potassium, sodium, niobium, and oxygen, wherein
in a plurality of crystal grains observed on a sputter surface, a number-average grain size Nd and an area-average grain size Nv satisfy a relationship formula of $(Nv - Nd)/Nd \leq 2.1$.

(Supplementary description 6)

According to further another aspect of the present disclosure, there is provided a sputtering target material comprising a sintered ceramics of an oxide containing potassium, sodium, niobium, and oxygen, wherein
in a plurality of crystal grains observed on a sputter surface, an area-average grain size Nv and an area-average standard deviation Ns satisfy a relationship formula of $Ns/Nv \leq 0.76$.

(Supplementary description 7)

According to further another aspect of the present disclosure, there is provided a sputtering target material comprising a sintered ceramics of an oxide containing potassium, sodium, niobium, and oxygen, wherein

when a sputter surface is observed by an EBSD method and an area ratio of crystal grains with $<103>_{0\text{-}10°}$ orientation is defined as $A_{<103>}$,
the area ratio $A_{<103>}$ per unit area of the sputter surface is 0.061 or more.

(Supplementary description 8)

According to further another aspect of the present disclosure, there is provided a sputtering target material comprising a sintered ceramics of an oxide containing potassium, sodium, niobium, and oxygen, wherein

when a sputter surface is observed by an EBSD method,
when a total area ratio of a crystal plane with $<101>_{0\text{-}10°}$ orientation, a crystal plane with $<010>_{0\text{-}10°}$ orientation, a crystal plane with $<111>_{0\text{-}10°}$ orientation, a crystal plane with $<103>_{0\text{-}10°}$ orientation, a crystal plane with $<212>_{0\text{-}10°}$ orientation, and a crystal plane with $<121>_{0\text{-}10°}$ orientation is defined as A, and
when an area ratio of the crystal plane with the $<103>_{0\text{-}10°}$ orientation is defined as $A_{<103>}$,
a ratio of the $A_{<103>}$ to the A is 0.165 or more.

(Supplementary description 9)

Preferably, there is provided the sputtering target material, wherein

when the sputter surface is observed by an EBSD method, and
a total area ratio of the crystal plane with the $<212>_{0\text{-}10°}$ orientation and the crystal plane with the $<121>_{0\text{-}10°}$ orientation is defined as $A_{<212>+<121>}$,
a ratio of the $A_{<212>+<121>}$ to the A is 0.580 or less.

(Supplementary description 10)

Preferably, there is provided the sputtering target material, wherein

when the sputter surface is observed by an EBSD method, and
an area ratio of the crystal plane with the $<101>_{0\text{-}10°}$ is defined as $A_{<101>}$,
a ratio of the $A_{<101>}$ to the A is less than 0.130.

(Supplementary description 11)

Preferably, there is provided the sputtering target material, wherein
the total area ratio A per unit area of the sputter surface observed by an EBSD method is 0.40 or more.

(Supplementary description 12)

According to further another aspect of the present disclosure, there is provided a sputtering target material comprising a sintered ceramics of an oxide containing potassium, sodium, niobium, and oxygen, wherein
a carbon concentration when a volume resistivity at 25 °C is less than $6.0 \times 10^{11}$ $\Omega \cdot$cm is 200 ppm or less.

(Supplementary description 13)

According to another aspect of the present disclosure, there is provided a sputtering target material comprising a sintered ceramics of an oxide containing potassium, sodium, niobium, and oxygen, wherein
a carbon concentration when a volume resistivity at 25 °C is $6.0 \times 10^{11}$ $\Omega \cdot$cm or more is 90 ppm or less.

(Supplementary description 14)

According to further another aspect of the present disclosure, there is provided a sputtering target material comprising a sintered ceramics of an oxide containing potassium, sodium, niobium, and oxygen, wherein
a content of carbon component when a volume resistivity at 25 °C is less than $6.0 \times 10^{11}$ $\Omega \cdot$cm is $5.0 \times 10^{-9}$ mol or less (i.e., $5.0 \times 10^{-9}$ mol/mg or less) in total as converted to carbon dioxide and carbon monoxide, per 1 mg in mass of the sputter target material 10.

(Supplementary description 15)

According to further another aspect of the present disclosure, there is provided a sputtering target material comprising a sintered ceramics of an oxide containing potassium, sodium, niobium, and oxygen, wherein
a content of carbon component when a volume resistivity at 25 °C is $6.0 \times 10^{11}$ $\Omega \cdot$cm or more is $4.0 \times 10^{-9}$ mol or less (i.e., $4.0 \times 10^{-9}$ mol/mg or less) in total as converted to carbon dioxide and carbon monoxide, per 1 mg in mass of the sputter target material 10.

(Supplementary description 16)

According to further another aspect of the present disclosure, there is provided a sputtering target material comprising a sintered ceramics of an oxide containing potassium, sodium, niobium, and oxygen, wherein

> a ratio of a total area of voids per unit area of a sputter surface is 12.0 % or less, and
> an average diameter of voids present on the sputter surface is 0.60 $\mu$m or less.

(Supplementary description 17)

Preferably, there is provided the sputtering target material, wherein
a maximum diameter of a void present on the sputter surface is 1.0 $\mu$m or less.

(Supplementary description 18)

Preferably, there is provided the sputtering target material, containing, as a dopant, at least one element selected from the group consisting of Li, Mg, Ca, Sr, Ba, Bi, Sb, V, In, Ta, Mo, W, Cr, Ti, Zr, Hf, Sc, Y, La, Ce, Pr, Nd, Sm, Eu, Gd, Tb, Dy, Ho, Er, Tm, Yb, Lu, Cu, Zn, Ag, Mn, Fe, Co, Ni, Al, Si, Ge, Sn, and Ga.

(Supplementary description 19)

Preferably, there is provided the sputtering target material, having a main surface with an area of 4500 mm$^2$ or more.

(Supplementary description 20)

According to further another aspect of the present disclosure, there is provided a sputtering target comprising:

the sputtering target material according to any one of the supplementary descriptions 1 to 19; and

a backing plate joined to the sputtering target material.

DESCRIPTION OF SIGNS AND NUMERALS

10      Target

10s     Sputter surface

**Claims**

1.  A sputtering target material comprising a sintered ceramics of an oxide containing potassium, sodium, niobium, and oxygen, wherein
    when a volume resistivity at 25 °C is less than $6.0 \times 10^{11}$ $\Omega$·cm, a Vickers hardness is 460 or more, and a flexural strength is 90 MPa or more.

2.  A sputtering target material comprising a sintered ceramics of an oxide containing potassium, sodium, niobium, and oxygen, wherein
    when a volume resistivity at 25 °C is $6.0 \times 10^{11}$ $\Omega$·cm or more, a Vickers hardness is 250 or more, and a flexural strength is 90 MPa or more.

3.  The sputtering target material according to claim 1 or 2, wherein a Vickers hardness after heat treatment at 900 °C for 5 hours in air is maintained at a magnitude exceeding 50 % of a Vickers hardness before the heat treatment.

4.  The sputtering target material according to claim 1 or 2, wherein a relative density after heat treatment at 900 °C for 5 hours in air is maintained at a magnitude exceeding 95 % of a relative density before the heat treatment.

5.  The sputtering target material according to claim 1 or 2, containing, as a dopant, at least one element selected from the group consisting of Li, Mg, Ca, Sr, Ba, Bi, Sb, V, In, Ta, Mo, W, Cr, Ti, Zr, Hf, Sc, Y, La, Ce, Pr, Nd, Sm, Eu, Gd, Tb, Dy, Ho, Er, Tm, Yb, Lu, Cu, Zn, Ag, Mn, Fe, Co, Ni, Al, Si, Ge, Sn, and Ga.

6.  The sputtering target material according to claim 1 or 2, having a main surface with an area of 4500 mm$^2$ or more.

7.  A sputtering target comprising:

    the sputtering target material according to claim 1 or 2; and
    a backing plate joined to the sputtering target material.

FIG. 1

## FIG. 2

```
┌─────────────────────────────────────────┐
│   Preparation of starting material powders │
└─────────────────────────────────────────┘
                    ↓
┌─────────────────────────────────────────┐
│            Weighing and mixing            │
└─────────────────────────────────────────┘
                    ↓
┌─────────────────────────────────────────┐
│        Primary firing and crushing        │
└─────────────────────────────────────────┘
                    ↓
┌─────────────────────────────────────────┐
│          Calcination and crushing         │
└─────────────────────────────────────────┘
                    ↓
┌─────────────────────────────────────────┐
│                Pulverizing                │
└─────────────────────────────────────────┘
                    ↓
┌─────────────────────────────────────────┐
│              Low pressure SPS             │
└─────────────────────────────────────────┘
                    ↓
┌─────────────────────────────────────────┐
│                 Main SPS                  │
└─────────────────────────────────────────┘
                    ↓
┌─────────────────────────────────────────┐
│             Oxidation treatment           │
└─────────────────────────────────────────┘
                    ↓
┌─────────────────────────────────────────┐
│     Grinding and joining to backing plate  │
└─────────────────────────────────────────┘
```

# FIG. 3

## INTERNATIONAL SEARCH REPORT

| International application No. |
|---|
| **PCT/JP2022/041920** |

**A. CLASSIFICATION OF SUBJECT MATTER**

***C23C 14/34***(2006.01)i; ***C04B 35/495***(2006.01)i; ***H10N 30/853***(2023.01)i
FI:  C23C14/34 A; C04B35/495; H01L41/187

According to International Patent Classification (IPC) or to both national classification and IPC

**B. FIELDS SEARCHED**

Minimum documentation searched (classification system followed by classification symbols)

C23C14/34; C04B35/495; H01L41/187

Documentation searched other than minimum documentation to the extent that such documents are included in the fields searched

Published examined utility model applications of Japan 1922-1996
Published unexamined utility model applications of Japan 1971-2022
Registered utility model specifications of Japan 1996-2022
Published registered utility model applications of Japan 1994-2022

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
|---|---|---|
| A | WO 2019/167657 A1 (JX NIPPON MINING & METALS CORP.) 06 September 2019 (2019-09-06)<br>entire text | 1-7 |
| A | JP 2020-183581 A (JX NIPPON MINING & METALS CORP.) 12 November 2020 (2020-11-12)<br>entire text | 1-7 |
| A | JP 2019-161074 A (SCIOCS CO., LTD.) 19 September 2019 (2019-09-19)<br>entire text | 1-7 |
| A | JP 2012-167316 A (HITACHI CABLE LTD.) 06 September 2012 (2012-09-06)<br>entire text | 1-7 |
| A | JP 2007-022854 A (TOYOTA MOTOR CORP.) 01 February 2007 (2007-02-01)<br>entire text | 1-7 |
| A | WO 2005/021461 A1 (NATIONAL INST. OF ADVANCED INDUSTRIAL SCIENCE AND TECHNOLOGY) 10 March 2005 (2005-03-10)<br>entire text | 1-7 |

☑ Further documents are listed in the continuation of Box C.    ☑ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed

"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| **19 December 2022** | **10 January 2023** |

| Name and mailing address of the ISA/JP | Authorized officer |
|---|---|
| **Japan Patent Office (ISA/JP)**<br>**3-4-3 Kasumigaseki, Chiyoda-ku, Tokyo 100-8915**<br>**Japan** | |
| | Telephone No. |

Form PCT/ISA/210 (second sheet) (January 2015)

**INTERNATIONAL SEARCH REPORT**

International application No.

**PCT/JP2022/041920**

**C.    DOCUMENTS CONSIDERED TO BE RELEVANT**

| Category* | Citation of document, with indication, where appropriate, of the relevant passages | Relevant to claim No. |
|---|---|---|
| P, A | JP 2022-165643 A (SUMITOMO CHEMICAL CO., LTD.) 01 November 2022 (2022-11-01) entire text | 1-7 |
| P, A | WO 2022/224594 A1 (SUMITOMO CHEMICAL CO., LTD.) 27 October 2022 (2022-10-27) entire text | 1-7 |

Form PCT/ISA/210 (second sheet) (January 2015)

INTERNATIONAL SEARCH REPORT
Information on patent family members

International application No.

**PCT/JP2022/041920**

| Patent document cited in search report | | | Publication date (day/month/year) | Patent family member(s) | | | Publication date (day/month/year) |
|---|---|---|---|---|---|---|---|
| WO | 2019/167657 | A1 | 06 September 2019 | US 2020/0370168 A1 entire text EP 3660183 A1 | | | |
| JP | 2020-183581 | A | 12 November 2020 | US 2020/0340096 A1 entire text EP 3730668 A2 JP 2020-183574 A JP 6756886 B1 | | | |
| JP | 2019-161074 | A | 19 September 2019 | US 2019/0288180 A1 entire text EP 3540797 A1 | | | |
| JP | 2012-167316 | A | 06 September 2012 | (Family: none) | | | |
| JP | 2007-022854 | A | 01 February 2007 | (Family: none) | | | |
| WO | 2005/021461 | A1 | 10 March 2005 | (Family: none) | | | |
| JP | 2022-165643 | A | 01 November 2022 | (Family: none) | | | |
| WO | 2022/224594 | A1 | 27 October 2022 | (Family: none) | | | |

Form PCT/ISA/210 (patent family annex) (January 2015)

**EP 4 435 141 A1**

## REFERENCES CITED IN THE DESCRIPTION

**Patent documents cited in the description**

- JP 2011146623 A
- JP 2018197181 A